(19) Europäisches Patentamt
European Patent Office
Office européen des brevets

(11) EP 4 227 377 A1

(12) **EUROPEAN PATENT APPLICATION**
published in accordance with Art. 153(4) EPC

(43) Date of publication:
**16.08.2023 Bulletin 2023/33**

(21) Application number: **21877544.3**

(22) Date of filing: **04.10.2021**

(51) International Patent Classification (IPC):
***C09J 11/06*** (2006.01) ***H01L 23/29*** (2006.01)
***H01L 23/31*** (2006.01) ***C09J 171/02*** (2006.01)
***C09J 183/05*** (2006.01) ***C09J 183/06*** (2006.01)
***C09J 183/07*** (2006.01) ***H01L 21/52*** (2006.01)

(52) Cooperative Patent Classification (CPC):
**C09J 11/06; C09J 171/02; C09J 183/04; C09J 183/06; H01L 21/52; H01L 23/29; H01L 23/31**

(86) International application number:
**PCT/JP2021/036571**

(87) International publication number:
**WO 2022/075245 (14.04.2022 Gazette 2022/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.10.2020 JP 2020169602**

(71) Applicant: **SHIN-ETSU CHEMICAL CO., LTD.**
**Tokyo 1000005 (JP)**

(72) Inventors:
- **HAYASHI Ryuto**
  **Annaka-shi, Gunma 379-0224 (JP)**
- **KOSHIKAWA Hidenori**
  **Annaka-shi, Gunma 379-0224 (JP)**
- **FUKUDA Kenichi**
  **Annaka-shi, Gunma 379-0224 (JP)**

(74) Representative: **Ter Meer Steinmeister & Partner Patentanwälte mbB**
**Nymphenburger Straße 4**
**80335 München (DE)**

(54) **ADHESIVE COMPOSITION, DIE ATTACH MATERIAL, SEALING AGENT OR COATING AGENT FOR PROTECTION, AND ELECTRICAL/ELECTRONIC COMPONENT**

(57) This perfluoropolyether-based adhesive composition contains:
(A) a linear perfluoropolyether compound containing two or more alkenyl groups in one molecule and having a number average molecular weight of 2,000 or more and a weight loss ratio of 1% or less when heated at 150°C for 1 hour;
(B) a fluorine-containing organohydrogenpolysiloxane compound which contains at least one fluorine-containing organic group, and does not contain an epoxy group and a trialkoxysilyl group, and which has a number average molecular weight of 1,000-4,000 and a weight loss ratio of 20% or less when heated at 150°C for 1 hour;
(C) a platinum group metal compound; and
(D) an organohydrogenpolysiloxane compound which contains at least one of each of an epoxy group and/or a trialkoxysilyl group bonded to a silicon atom via a carbon atom or a carbon atom and a hydrogen atom, and which has a number average molecular weight of 700 or more,
wherein the perfluoropolyether-based adhesive composition is used to provide a cured product of a fluorine-containing elastomer which has decreased contamination of peripheral parts caused by an outgas generated during heat-curing.

EP 4 227 377 A1

## Description

### TECHNICAL FIELD

The present invention relates to a perfluoropolyether adhesive composition which causes less contamination of surrounding parts by outgas generated during heat curing, firmly adheres to various substrates such as metals and plastics, and gives a fluorine-containing elastomer cured product that is excellent in solvent resistance, chemical resistance, heat resistance, low-temperature characteristics, low-moisture permeability, electrical characteristics and the like after curing, a die attach material, a sealing agent or coating agent for protection including the adhesive composition, and an in-vehicle sensor part or an electrical or electronic part such as a part for a printing or copying device or a fuel cell having a cured product of the adhesive composition.

### BACKGROUND ART

Curable fluorine-containing elastomer compositions utilizing an addition reaction between an alkenyl group and a hydrosilyl group are known, and a composition to which self-adhesive property is imparted by adding as a third component (adhesiveness improver), an organopolysiloxane having a hydrosilyl group and an epoxy group and/or a trialkoxysilyl group to the composition has been proposed (Patent Document 1: JP-A H09-95615). The composition can be cured by heating in a short time, and the obtained cured product (fluorine-containing elastomer cured product) is excellent in solvent resistance, chemical resistance, heat resistance, low-temperature characteristics, low-moisture permeability, electrical characteristics and the like, and thus is used for adhesion applications in various industrial fields in which these characteristics are required.

However, it has been pointed out that gaseous impurities (generally referred to as "outgas") are generated during heat curing of the composition, and this contaminates peripheral parts, thereby causing defects. For example, when the composition is used as a sealing agent in a head portion of an inkjet printer, the vicinity of an ink discharge path and a discharge port is contaminated by an outgas (gaseous fluorine-containing low molecular weight compound) generated during heat curing, and there is a problem that dischargeability of the ink changes. Also in a production process of an in-vehicle sensor or the like, in a case where the composition is used as a material (die attach material) for fixing a chip on a substrate such as a resin, a gold pad on the chip is contaminated due to contamination by outgas, and a defect that wire bonding cannot be performed occurs. This outgas is considered to be generated by volatilization of not only the perfluoropolyether compound having a low polymerization degree in a main component (base polymer) or the fluorine-containing organohydrogen siloxane which is a crosslinking agent contained in the composition, but also a low molecular weight component such as a fluorine-containing organic compound or a non-fluorine-based organic compound blended as an adhesiveness improver from the composition, before the curing reaction is completed by heating. As a means for suppressing contamination of surrounding parts by the outgas, it is known to use an adhesive composition with very small volatile content at 105°C in which each molecular weight of a fluorine-containing organic compound and a non-fluorine-based organic compound used as adhesiveness improver component is 2,000 or more (Patent Document 2: JP 4582287).

### PRIOR ART DOCUMENTS

### PATENT DOCUMENTS

Patent Document 1: JP-A H09-95615
Patent Document 2: JP 4582287

### SUMMARY OF INVENTION

### TECHNICAL PROBLEM

By using a perfluoropolyether adhesive composition made of only components having a molecular weight of 2,000 or more, outgas is reduced, while the viscosity of high molecular weight components other than the base polymer is easily reflected in the viscosity of the entire adhesive composition. For example, when a high molecular weight fluorine-containing component having a viscosity lower than that of the base polymer (alkenyl group-containing perfluoropolyether compound) is blended, the viscosity of the resulting perfluoropolyether adhesive composition is likely to be low. In addition, when a high molecular weight fluorine-containing component having a viscosity higher than that of the base

polymer is blended, the viscosity of the resulting perfluoropolyether adhesive composition is likely to be high. Furthermore, a fluorine-containing elastomer cured product obtained by curing a perfluoropolyether adhesive composition containing those high molecular weight fluorine-containing components other than the base polymer is likely to be soft (low hardness). In die attach material applications, the perfluoropolyether adhesive composition is used to fix a sensor chip on a substrate, but when a fluorine-containing elastomer cured product obtained from the perfluoropolyether adhesive composition is soft, the chip cannot be firmly held due to flexibility of the fluorine-containing elastomer cured product, and wire bonding may be difficult. It is possible to increase the viscosity of the perfluoropolyether adhesive composition and improve physical properties of the fluorine-containing elastomer cured product by adding an inorganic filler, but adhesion to a metal, a resin or the like may be difficult to exhibit.

For the above reasons, in the perfluoropolyether adhesive composition, some or all components other than the base polymer preferably have a relatively low molecular weight, and a perfluoropolyether adhesive composition that causes less contamination of surrounding parts by outgas during curing is required.

Therefore, the present invention has been made in view of the above circumstances, and an object of the present invention is to provide a perfluoropolyether adhesive composition which gives a fluorine-containing elastomer cured product that causes less contamination of surrounding parts by outgas generated during heat curing, firmly adheres to various substrates such as metals and plastics, and is excellent in solvent resistance, chemical resistance, heat resistance, low-temperature characteristics, low-moisture permeability, electrical characteristics and the like after curing, a die attach material including the adhesive composition, a sealing agent or coating agent for protection including the adhesive composition, and an electrical or electronic part having a cured product of the adhesive composition.

## SOLUTION TO PROBLEM

As a result of intensive studies to solve the above problems, the present inventors have found that by blending a base polymer having a numerical average molecular weight of 2,000 or more and a small amount of low molecular weight components that cause outgas, and a crosslinking agent having a numerical average molecular weight of 1,000 or more and 4,000 or less in combination, a perfluoropolyether adhesive composition that causes little contamination of surrounding parts by outgas during heat curing even when the numerical average molecular weight of a fluorine-containing organic compound or a non-fluorine-based organic compound that is an adhesiveness improver is not 2,000 or more (specifically, even when the adhesiveness improver is a component having a relatively low molecular weight of about 700 to 2,000), and have completed the present invention.

Therefore, the present invention provides the following adhesive composition, a die attach material including the adhesive composition, a sealing agent or coating agent for protection including the adhesive composition, and an electrical or electronic part having a cured product of the adhesive composition.

[1] An adhesive composition comprising:

(A) 100 parts by weight of a linear perfluoropolyether compound having at least two alkenyl groups in one molecule, and having a numerical average molecular weight of 2,000 or more and a weight loss ratio of 1% or less upon heating component (A) alone at 150°C for 1 hour,
(B) a fluorine-containing organohydrogenpolysiloxane compound having two or more hydrogen atoms bonded to silicon atoms in one molecule and one or more fluorine-containing organic groups, being free of an epoxy group and a trialkoxysilyl group, and having a numerical average molecular weight of 1,000 or more and 4,000 or less and a weight loss ratio of 20% or less upon heating component (B) alone at 150°C for 1 hour, component (B) being present in an amount to give 0.1 to 2.5 mol of hydrogen atoms bonded to silicon atoms in the component (B) per mol of alkenyl groups in the component (A),
(C) 0.1 to 1,000 ppm in terms of platinum group metal atom with respect to the mass of the component (A) of a platinum group metal compound, and
(D) an organohydrogenpolysiloxane compound having one or more hydrogen atoms bonded to silicon atoms and one or more epoxy groups and/or trialkoxysilyl groups bonded to silicon atoms via a carbon atom or a carbon atom and an oxygen atom in one molecule, and having a numerical average molecular weight of 700 or more, component (D) being present in an amount to give 0.005 to 1.5 mol of hydrogen atoms bonded to silicon atoms in the component (D) per mol of alkenyl groups in the component (A).

[2] The adhesive composition according to [1], wherein the component (A) is a linear perfluoropolyether compound having the following general formula (1):

[Chem. 1]

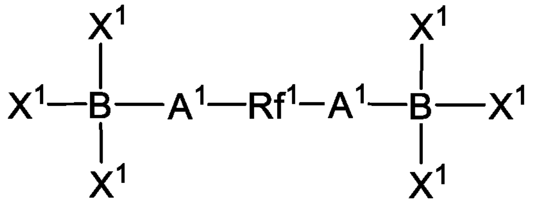

(1)

wherein each $A^1$s is independently any one group selected from a divalent organic group having 1 to 4 carbon atoms which may contain an ether bond or an amide bond, a group having the following general formula (2), and a group having the general formula (3),

[Chem. 2]

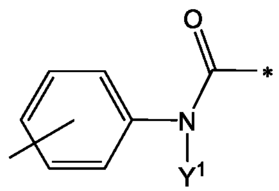

(2)

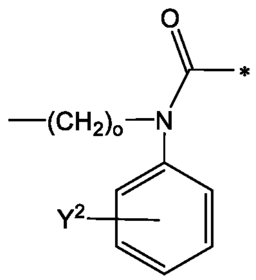

(3)

wherein $Y^1$ is a hydrogen atom, a methyl group, an ethyl group, or a phenyl group, $Y^2$ is a hydrogen atom, a methyl group, an ethyl group, or a trifluoromethyl group, o is an integer of 1 to 6, and a bond with * represents bonding to $Rf^1$, B is a carbon atom or silicon atom, each $X^1$s is independent, at least two $X^1$s are alkenyl groups, the other $X^1$s are hydrogen atoms (only when B is a carbon atom) or methyl groups, and $Rf^1$ is a divalent perfluoropolyether group.

[3] The adhesive composition according to [1] or [2], wherein the component (A) has a weight loss ratio of 0.5% or less upon heating the component (A) alone at 150°C for 1 hour.

[4] The adhesive composition according to any one of [1] to [3], wherein the alkenyl group content of the component (A) is 0.002 to 0.3 mol/100 g.

[5] The adhesive composition according to any one of [1] to [4], wherein the component (B) is a fluorine-containing organohydrogenpolysiloxane compound having the following general formula (4):

[Chem. 3]

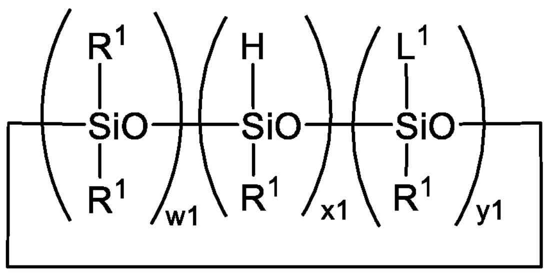

(4)

wherein $R^1$s are unsubstituted or halogen-substituted monovalent hydrocarbon groups, $L^1$ is a monovalent fluorine-containing organic group containing a monovalent perfluoropolyether group having the following general formula (5) which may be bonded to a silicon atom via a divalent linking group, w1 is an integer of 0 to 50, x1 is an integer of 2 to 50, y1 is an integer of 1 to 50, w1 + x1 + y1 is an integer satisfying a numerical average molecular weight of 1,000 to 4,000, and the repeating units in parentheses may be randomly arranged,

$$E\text{-}(C_4F_8O)_c\text{-}(C_3F_6O)_d\text{-}(C_2F_4O)_e\text{-}(CF_2O)_f\text{-}C_gF_{2g}\text{-} \quad (5)$$

wherein E is a fluorine atom or a perfluorooxyalkyl group having 1 to 6 carbon atoms, c, d, e, and f are each independently an integer of 0 to 20, $2 \leq c + d + e + f \leq 20$, g is an integer of 1 to 3, and the repeating units in parentheses may be randomly arranged.

[6] The adhesive composition according to any one of [1] to [5], wherein the component (D) has one or more monovalent perfluoroalkyl groups or monovalent perfluorooxyalkyl groups bonded to silicon atoms via a divalent linking group containing at least one selected from a nitrogen atom, a carbon atom, and an oxygen atom in one molecule.
[7] The adhesive composition according to any one of [1] to [6], further containing 0.010 to 10 parts by weight of a carboxylic anhydride (E) per 100 parts by weight of the component (A).
[8] A die attach material including the adhesive composition according to any one of [1] to [7].
[9] The die attach material according to [8], which is used for an in-vehicle sensor.
[10] A sealing agent or coating agent for protection including the adhesive composition according to any one of [1] to [7].
[11] The sealing agent or coating agent for protection according to [10], which is used for a printing or copying device or a fuel cell.
[12] An electrical or electronic part including a cured product of the adhesive composition according to any one of [1] to [7].
[13] The electrical or electronic part according to [12], which is an in-vehicle sensor article in which a sensor chip is fixed with the cured product of the adhesive composition.
[14] The electrical or electronic part according to [12], which is a part for a printing or copying device or a part for a fuel cell in which the cured product of the adhesive composition is used as a seal or coating layer for protection.

## ADVANTAGEOUS EFFECTS OF INVENTION

According to the adhesive composition of the present invention, it is possible to give a cured product that causes extremely less contamination of surrounding parts by outgas generated during heat curing, firmly adheres to various substrates such as metals and plastics, and is excellent in solvent resistance, chemical resistance, heat resistance, low-temperature characteristics, low-moisture permeability, electrical characteristics and the like after curing.

## BRIEF DESCRIPTION OF DRAWINGS

[FIG. 1] FIG. 1 is a view showing a state of a sensor chip in a contamination confirmation test during heat curing in Example 1, in which (a) is an appearance photograph before the contamination confirmation test during heat curing,

and (b) is an appearance photograph after the contamination confirmation test during heat curing.

[FIG. 2] FIG. 2 is a view showing a state of a sensor chip in a contamination confirmation test during heat curing in Comparative Example 1, in which (a) is an appearance photograph before the contamination confirmation test during heat curing, and (b) is an appearance photograph after the contamination confirmation test during heat curing.

## DESCRIPTION OF EMBODIMENTS

Hereinafter, the present invention is described in more detail.

[Adhesive composition]

The adhesive composition according to the present invention is characterized by containing the following components (A), (B), (C), and (D).

[Component (A)]

The linear perfluoropolyether compound as the component (A) used in the adhesive composition of the present invention has at least two alkenyl groups in one molecule and a numerical average molecular weight of 2,000 or more, and a weight loss ratio of 1% or less upon heating component (A) alone at 150°C for 1 hour, preferably has a divalent perfluoroalkyl ether structure in a main chain as having the general formula (1) described later, and acts as a main component (base polymer) in the adhesive composition of the present invention.

In the present invention, the polymerization degree (or molecular weight) of the linear polyfluoro compound reflecting the number of repetitions of the perfluorooxyalkylene unit constituting the perfluoropolyether structure of a main chain can be determined, for example, as a numerical average polymerization degree (or numerical average molecular weight average molecular weight) in terms of polystyrene in gel permeation chromatography (GPC) analysis using a fluorine-based solvent as a developing solvent. Furthermore, the numerical average polymerization degree (or numerical average molecular weight) of the linear polyfluoro compound can also be calculated from $^{19}$F-NMR.

The component (A) has a numerical average molecular weight of 2,000 or more, and particularly desirably 4,000 or more obtained by the synthesis method described in JP-A 9-95615. The linear perfluoropolyether compound having a numerical average molecular weight of less than 2,000 is not preferable because the proportion of the linear perfluoropolyether compound itself volatilized as an outgas during heat curing increases, that causes contamination of surrounding parts. The upper limit of the numerical average molecular weight may be 50,000 or less, particularly about 20,000 or less.

In addition, the linear perfluoropolyether compound as the component (A) has a weight loss ratio of 1% or less, preferably 0.5% or less when the component (A) is heated alone at 150°C for 1 hour (heat treatment at 150°C).

When the linear perfluoropolyether compound (A) has a weight loss ratio of more than 1% (in particular, 1.0%) by the heat treatment at 150°C, outgas is generated from the adhesive composition containing this compound during heat curing to cause contamination.

Here, the weight loss ratio can be determined by the following measurement method. A tare of a clean aluminum dish (W1) is weighed using a precision balance (reading limit: 0.0001 mg). Next, a sample is collected in the aluminum dish, and a mass of the aluminum dish on which the sample is placed (W2) is weighed using a precision balance. The aluminum dish on which the sample is placed is left in a thermostat (in the atmosphere) at 150°C for 1 hour. After the heating, the aluminum dish is taken out from the thermostat and cooled in a desiccator. After the cooling, a mass of the aluminum dish on which the sample is placed (W3) is weighed using the precision balance. The weight loss ratio of this sample is determined from the following formula.

$$\{(W3 - W1)/(W2 - W1)\} \times 100 \text{ (unit: \%)}$$

W1: Mass of aluminum dish (g)
W2: Mass of aluminum dish + mass of sample before heating (g)
W3: Mass of aluminum dish + mass of sample after heating (g)

The method for measuring the weight loss ratio is the same for the components (B) and (D) described later.

Incidentally, the linear perfluoropolyether compound having the general formula (1) described later may inevitably contain a component having a numerical average molecular weight of less than 2,000 at least among perfluoropolyether compounds having a small degree of polymerization contained therein, and this may cause outgas.

Therefore, the component (A) from which the low molecular weight component has been removed may be

prepared by subjecting the linear perfluoropolyether compound having the general formula (1) described later to, for example, the following operation 1 as a pretreatment.

[Operation 1]

The component (A) is obtained by subjecting a linear perfluoropolyether compound, preferably a linear perfluoropolyether compound having the general formula (1) described later, to a reduced pressure treatment at a pressure of 1,330 Pa or less, preferably 665 Pa or less, at a temperature of 100 to 300°C, preferably 150 to 250°C, for 1 hour or more, preferably 5 hours or more.

The component (A) is preferably a linear perfluoropolyether compound having a structure having the following general formula (1). In the present invention, the term "linear" means that perfluorooxyalkylene units which are repeating units constituting the perfluoropolyether structure of a main chain are linearly bonded (linked) to each other, and each perfluorooxyalkylene unit itself may have a branched structure such as, for example, a $[OCF_2CF(CF_3)]$ unit.

[Chem. 4]

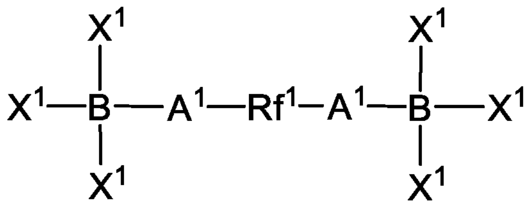
(1)

wherein each $A^1$s is independently any one group selected from divalent organic groups having 1 to 4 carbon atoms which may contain an ether bond or an amide bond, groups having the following general formula (2), and groups having the general formula (3),

[Chem. 5]

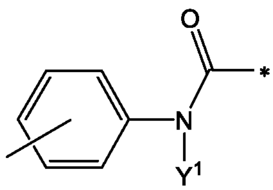
(2)

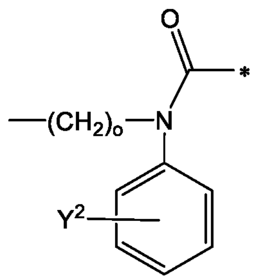
(3)

wherein $Y^1$ is a hydrogen atom, a methyl group, an ethyl group, or a phenyl group, $Y^2$ is a hydrogen atom, a methyl group, an ethyl group, or a trifluoromethyl group, o is an integer of 1 to 6, and a bond with * represents bonding to $Rf^1$, B is a carbon atom or a silicon atom, $X^1$s are each independent, among six (three at each of both terminals of the molecular chain) $X^1$s present in the molecule, at least two $X^1$s are alkenyl groups, the other $X^1$s are hydrogen atoms (only when B is a carbon atom) or methyl groups, and $Rf^1$ is a divalent perfluoropolyether group.

In the general formula (1), $A^1$ is any one group selected from divalent organic groups having 1 to 4 carbon atoms which may contain an ether bond or an amide bond, groups having the following general formula (2), and groups having the general formula (3).

[Chem. 6]

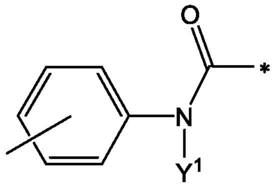
(2)

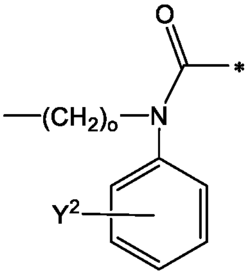
(3)

wherein $Y^1$ is a hydrogen atom, a methyl group, an ethyl group, or a phenyl group, $Y^2$ is a hydrogen atom, a methyl group, an ethyl group, or a trifluoromethyl group, o is an integer of 1 to 6, and a bond with * represents bonding to $Rf^1$ (the same applies hereinafter).

Examples of $A^1$ include $-CH_2-*$, $-OCH_2-*$, $-CH_2CH_2OCH_2-*$, $-CH_2-NH-CO-*$, $-CH_2CH_2-NH-CO-*$, $-CH_2-NCH_3-CO-*$, and groups having the following general formulas (2A), (2B), (2C), (3A), (3B), and (3C), and among them, groups having the general formula (2A) or (3A) are preferable. Me represents a methyl group, and Et represents an ethyl group.

[Chem. 7]

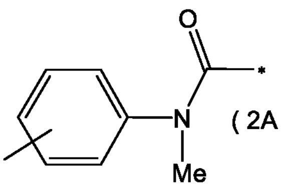
( 2A )
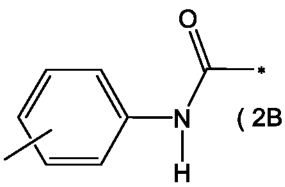
( 2B )
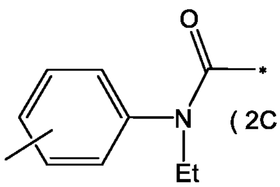
( 2C )

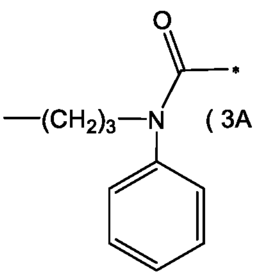
( 3A )
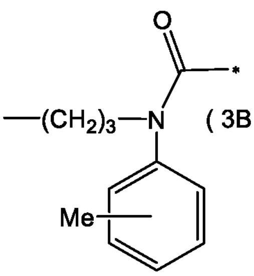
( 3B )
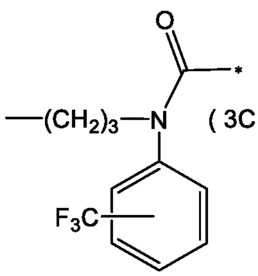
( 3C )

In the general formula (1), B is a carbon atom or a silicon atom.

In addition, among six (i.e., three at each of both terminals of the molecular chain) $X^1$s present in the molecule, at least two (in particular, at least one $X^1$ among three $X^1$s present at each of both terminals of the molecular chain) $X^1$s are alkenyl groups, and groups having 2 to 8 carbon atoms, particularly 2 to 6 carbon atoms, and having a $CH_2$=CH- structure at the terminal are preferable. Examples thereof include a vinyl group, an allyl group, a propenyl group, an isopropenyl group, a butenyl group, a hexenyl group, and the like, and among them, a vinyl group and an allyl group are preferable. In a case where $X^1$ is not an alkenyl group, the general formula (1) has a structure of $X^1$ is either a hydrogen atom or a methyl group when B is a carbon atom, and $X^1$ is a methyl group when B is a silicon atom.

In the general formula (1), $Rf^1$ is a divalent perfluoropolyether group and contains a repeating unit of $-C_aF_{2a}O-$ (wherein a is an integer of 1 to 6), and examples thereof include those represented by the following formula (6):

$$-(C_aF_{2a}O)_x- \qquad (6)$$

wherein a is an integer of 1 to 6, and x is an integer of 5 to 600, preferably an integer of 10 to 400, and more preferably an integer of 30 to 200.

Examples of the repeating unit represented by the formula $-C_aF_{2a}O-$ include units having the following formulas.

$-CF_2O-$

$-CF_2CF_2O-$

$-CF_2CF_2CF_2O-$

$-CF(CF_3)CF_2O-$

$-CF_2CF_2CF_2CF_2O-$

$-CF_2CF_2CF_2CF_2CF_2CF_2O-$

Among these, units having the following formulas are particularly suitable.

$-CF_2O-$

$-CF_2CF_2O-$

$-CF_2CF_2CF_2O-$

$-CF(CF_3)CF_2O-$

The repeating unit in the divalent perfluoropolyether group may be composed of one of these repeating units alone, or may be composed of a combination of two or more thereof these repeating units.

In addition, the divalent perfluoropolyether group preferably contains structures of the following formulas (7) to (11):

[Chem. 8]

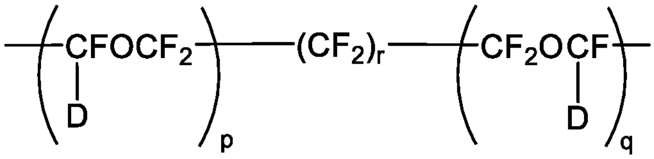

(7)

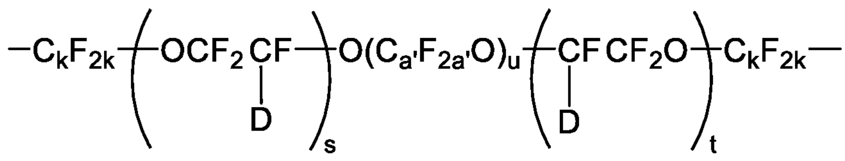

(8)

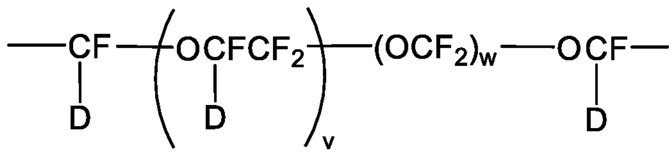

(9)

$$-CF_2CF_2-(OCF_2CF_2CF_2)_z-OCF_2CF_2- \quad (10)$$

$$-C_{k'}F_{2k'}-(OC_{a''}F_{2a''}OC_{a'''}F_{2a'''})_{z'}-OC_{k'}F_{2k'}- \quad (11)$$

wherein D is a fluorine atom or a trifluoromethyl group, p, q, and r are integers satisfying $p \geq 0$, $q \geq 0$, and $0 \leq p + q \leq 200$, particularly $2 \leq p + q \leq 150$, and $0 \leq r \leq 6$ (when $p + q = 0$, 1 <_ r < 6), respectively, k, a', s, t, and u are integers satisfying $1 \leq k \leq 3$, $2 \leq a' \leq 6$, $0 \leq s \leq 100$, $0 \leq t \leq 100$, $2 \leq s + t \leq 200$, and $0 \leq u \leq 6$, particularly $2 \leq s + t \leq 150$, $0 \leq u \leq 4$, and 2 <_ s + t + u ≤ 150, respectively, v and w are integers satisfying $1 \leq v \leq 100$, $1 \leq w \leq 100$, and $2 \leq v + w \leq 150$, respectively, z is an integer satisfying $1 \leq z \leq 200$, and k', a", and a‴ are integers satisfying $1 \leq k' \leq 3$, $1 \leq a'' \leq 6$, $1 \leq a'' \leq 6$, and $a'' \neq a'''$, respectively, z' is an integer satisfying 1 ≤ z' <_ 200, and the repeating units in parentheses of the formula (9) may be randomly arranged.

In the general formula (1), specific examples of $Rf^1$ include those having the following formulas (12) to (21):

[Chem. 9]

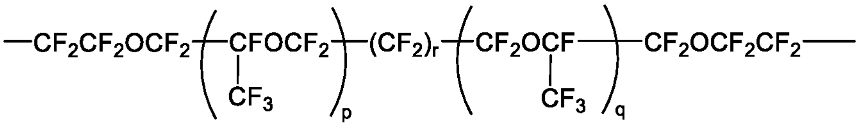 (12)

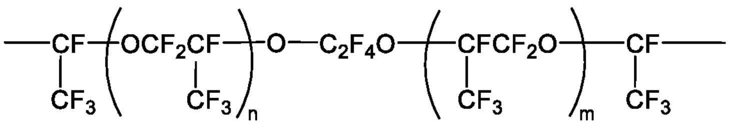 (13)

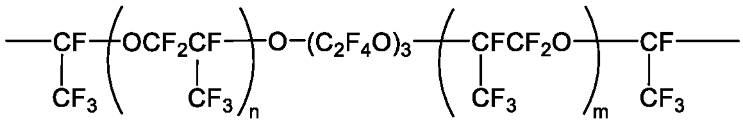 (14)

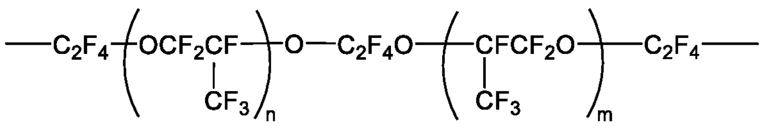 (15)

$$-CF_2O-(C_2F_4O)_{n1}-CF_2- \quad (16)$$

$$-CF_2-(OC_2F_4)_n-(OCF_2)_m-O-CF_2- \quad (17)$$

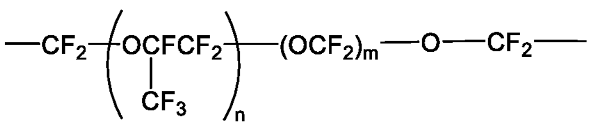 (18)

$$-CF_2CF_2-(OCF_2CF_2CF_2)_z-OCF_2CF_2- \quad (19)$$

$$-(C_2F_4O)_{n2}-CF_2CF_2- \quad (20)$$

$$-CF_2-(OC_2F_4OC_4F_8)_{z'}-OCF_2- \quad (21)$$

wherein in the formula (12), p, q, and r are integers satisfying $p \geq 0$, $q \geq 0$, and $0 \leq p + q \leq 200$, particularly $2 \leq p + q \leq 150$, and $0 \leq r \leq 6$, respectively, in the formulas (13), (14), (15), (17), and (18), n is an integer of 1 to 100, m is an integer of 1 to 100, and n + m is an integer of 2 to 200, in the formula (16), n1 is an integer of 2 to 200, in the formula (19), z is an integer of 1 to 200, in the formula (20), n2 is an integer of 2 to 200, in the formula (21), z' is an integer of 1 to 200, and the repeating units in parentheses in the formulas (17) and (18) may be randomly arranged.

As the component (A) having the general formula (1), when B is a silicon atom, those having the following formulas (22) to (35) are particularly suitable. Me represents a methyl group, and Et represents an ethyl group.

[Chem. 10]

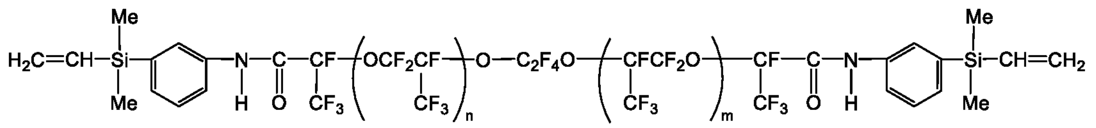
(22)

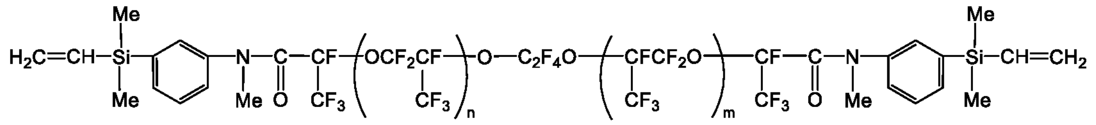
(23)

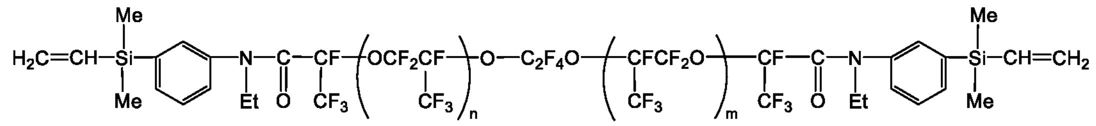
(24)

wherein m is an integer of 1 to 100, n is an integer of 1 to 100, and m + n is an integer of 2 to 200.

[Chem. 11]

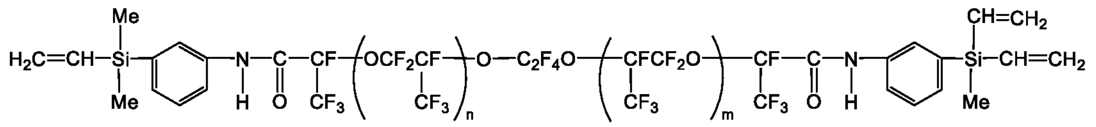
(25)

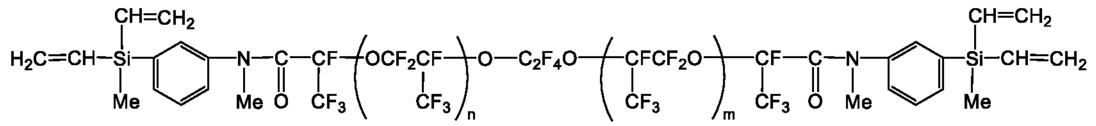
(26)

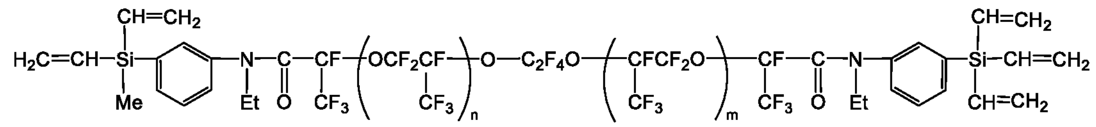
(27)

wherein m is an integer of 1 to 100, n is an integer of 1 to 100, and m + n is an integer of 2 to 200.

[Chem. 12]

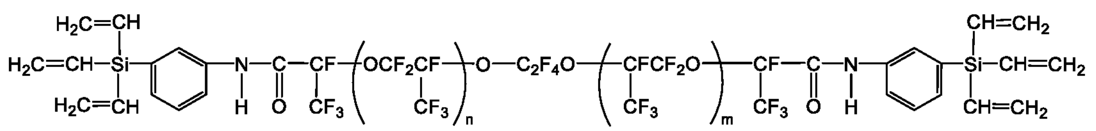
(28)

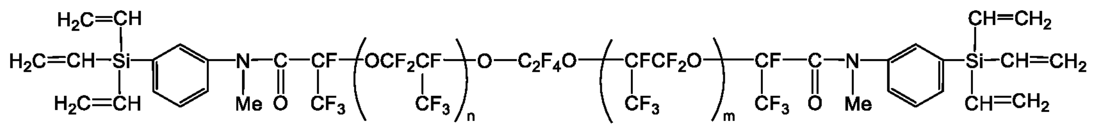
(29)

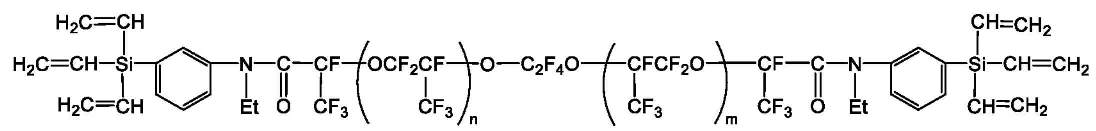
(30)

wherein m is an integer of 1 to 100, n is an integer of 1 to 100, and m + n is an integer of 2 to 200.

[Chem. 13]

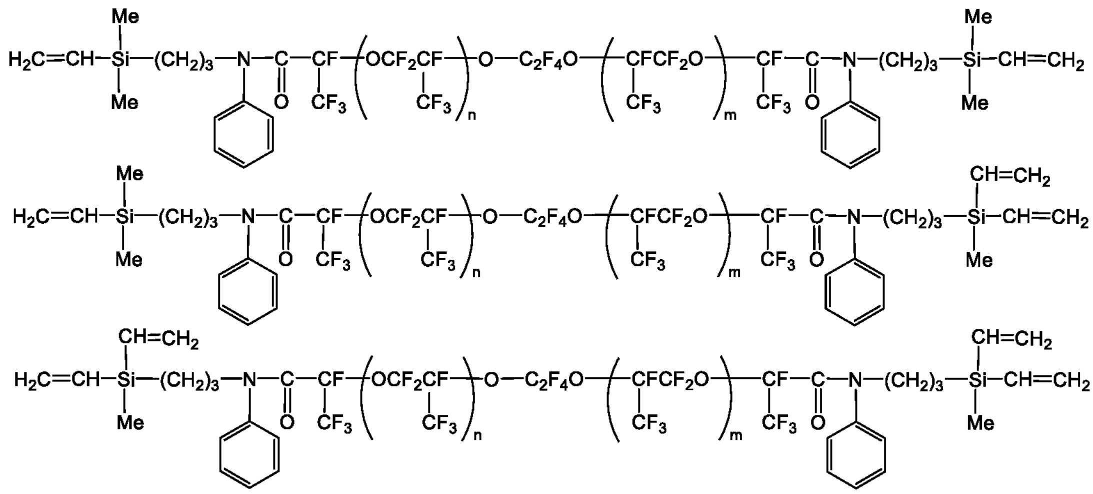

(31)

(32)

(33)

wherein m is an integer of 1 to 100, n is an integer of 1 to 100, and m + n is an integer of 2 to 200.

[Chem. 14]

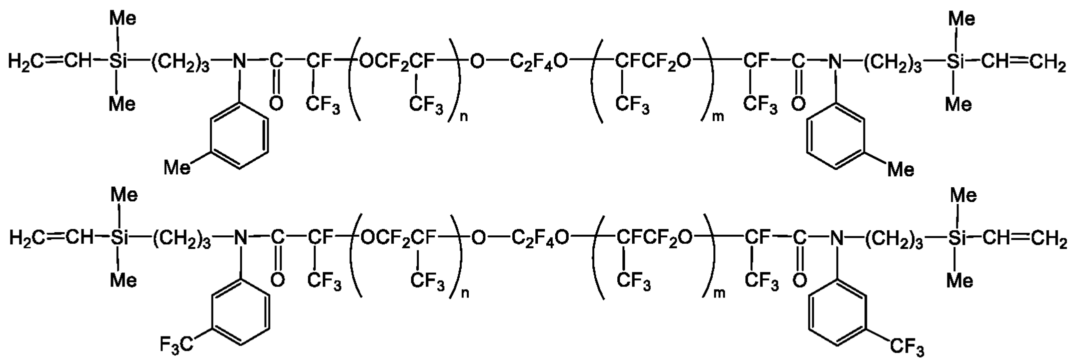

(34)

(35)

wherein m is an integer of 1 to 100, n is an integer of 1 to 100, and m + n is an integer of 2 to 200.

As the component (A) having the above general formula (1), when B is a carbon atom, those having the following formulas are suitable.

[Chem. 15]

$$CH_2{=}CH-CH_2-O-CH_2-CF_2-(OC_2F_4)_n-(OCF_2)_m-O-CF_2-CH_2-O-CH_2-CH{=}CH_2$$

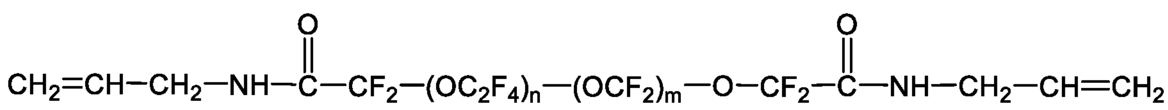

wherein m is an integer of 1 to 100, n is an integer of 1 to 100, and m + n is an integer of 2 to 200.

The content of the alkenyl group contained in the linear perfluoropolyether compound of the formula (1) is preferably 0.002 to 0.3 mol/100 g, and further preferably 0.008 to 0.12 mol/100 g. When the content of the alkenyl group contained in the linear perfluoropolyether compound is less than 0.002 mol/100 g, there is a possibility that the degree

of crosslinking becomes insufficient and curing failure occurs, which is not preferable, and when the content of the alkenyl group is more than 0.3 mol/100 g, there is a possibility that mechanical properties of the cured product as a rubber elastic body are impaired, which is not preferable.

It is desirable that the viscosity (23°C) of the linear perfluoropolyether compound as the component (A) is in the range of 40 to 100,000 mPa·s, more preferably 50 to 50,000 mPa·s, and further preferably 60 to 20,000 mPa·s since the composition of the present invention has appropriate physical properties also in the cured product when used for sealing, potting, coating, impregnation, and the like. Within the viscosity range, the most appropriate viscosity can be selected according to the application. In the present invention, the viscosity (23°C) can be measured with a rotational viscometer or the like (for example, a BL type, a BH type, a BS type, a cone and plate type, a rheometer, or the like) (the same applies to Examples).

As the component (A), these linear perfluoropolyether compounds can be used alone or in combination of two or more kinds thereof.

[Component (B)]

The component (B) used in the adhesive composition of the present invention is a fluorine-containing organohydrogenpolysiloxane compound having two or more hydrogen atoms bonded to silicon atoms (Si-H groups) in one molecule and one or more fluorine-containing organic groups, being free of an epoxy group and a trialkoxysilyl group, and having a numerical average molecular weight of 1,000 or more and 4,000 or less and a weight loss ratio of 20% or less upon heating component (B) alone at 150°C for 1 hour, and has functions as a crosslinking agent or a chain length extender for the component (A).

Here, the component (B) has a numerical average molecular weight of 1,000 to 4,000, and preferably 1,000 to 2,500. When the fluorine-containing organohydrogenpolysiloxane compound having a numerical average molecular weight of less than 1,000 is present in the adhesive composition, the fluorine-containing organohydrogenpolysiloxane compound itself volatilizes as an outgas during heat curing and causes contamination, which is not preferable. On the other hand, a fluorine-containing organohydrogenpolysiloxane compound having a numerical average molecular weight of more than 4,000 is not preferable because the viscosity of the compound itself is easily reflected in the adhesive composition, and it becomes difficult to keep the viscosity value of the adhesive composition within a specific range.

Also, the fluorine-containing organohydrogenpolysiloxane compound of the component (B) has a weight loss ratio of 20% or less when the component (B) is heated alone at 150°C for 1 hour (heat treatment at 150°C), and has a weight loss ratio of preferably 15% or less, and more preferably 8% or less. When the fluorine-containing organohydrogenpolysiloxane compound has a weight loss ratio of more than 20%, it is not preferable since outgas may be generated from the adhesive composition containing the fluorine-containing organohydrogenpolysiloxane compound during heat curing to cause contamination of surrounding parts.

In addition, the adhesive composition of the present invention is required to have the component (A) having a weight loss ratio of 1% (particularly, 1.0%) or less upon heating component (A) alone at 150°C for 1 hour and the component (B) having a weight loss ratio of 20% or less upon heating component (B) alone at 150°C for 1 hour. As a result, the outgas generation during heat curing of the adhesive composition of the present invention is suppressed, and contamination can be prevented.

In the component (B), from the viewpoint of compatibility with the component (A), dispersibility, uniformity after curing, and the like, the fluorine-containing organic group in the molecule more preferably has one or more perfluoroalkyl groups, perfluorooxyalkyl groups (monovalent perfluoropolyether groups), perfluoroalkylene groups, perfluorooxyalkylene groups (divalent perfluoropolyether groups), or the like in one molecule.

In particular, the component (B) preferably has a monovalent perfluoropolyether group having the following general formula (5).

$$E\text{-}(C_4F_8O)_c\text{-}(C_3F_6O)_d\text{-}(C_2F_4O)_e\text{-}(CF_2O)_f\text{-}C_gF_{2g}\text{-} \qquad (5)$$

E is a fluorine atom or a perfluorooxyalkyl group having 1 to 6 carbon atoms, c, d, e, and f are each independently an integer of 0 to 20, $2 \leq c + d + e + f \leq 20$, and g is an integer of 1 to 3, and the repeating units in parentheses may be randomly arranged.

In the general formula (5), when c + d + e + f is smaller than 2, the component (B) may volatilize as an outgas during heat curing of the adhesive composition to cause contamination, which is not preferable. On the other hand, when c + d + e + f is larger than 20, it is difficult to keep the viscosity value of the adhesive composition within a specific range, which is not preferable.

Examples of the monovalent perfluoropolyether group having the general formula (5) include the following:

[Chem. 16]

$$C_bF_{2b+1}O-(CF_2CF_2O)_{e'}-CF_2CF_2- \quad (36)$$

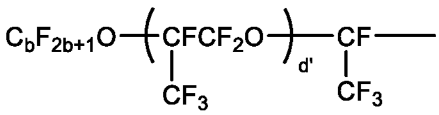

(37)

$$C_bF_{2b+1}O-(CF_2CF_2CF_2O)_{d'}-CF_2CF_2- \quad (38)$$

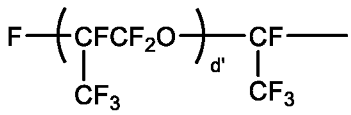

(39)

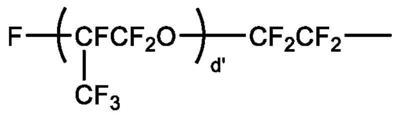

(40)

$$F-(CF_2CF_2O)_{e}-(CF_2O)_{f}-CF_2- \quad (41)$$

$$C_bF_{2b+1}O-(CF_2CF_2CF_2CF_2O)_{c'}-CF_2CF_2- \quad (42)$$

wherein b is an integer of 1 to 6, in the formula (36), e' is an integer of 2 to 20, in the formulas (37) to (40), d' is an integer of 2 to 20, in the formula (41), e and f are each an integer of 0 to 20, e + f is an integer of 2 to 20, and in the formula (42), c' is an integer of 2 to 20.

The monovalent perfluoropolyether group is bonded to a silicon atom in the (fluorine-containing) organohydrogenpolysiloxane compound, but a divalent linking group may be provided between the monovalent perfluoropolyether group and the silicon atom. The divalent linking group is any one group selected from divalent organic groups having 1 to 6 carbon atoms which may be bonded via an ether bond or an amide bond, groups having the following general formula (43A), and groups having the general formula (43B):

[Chem. 17]

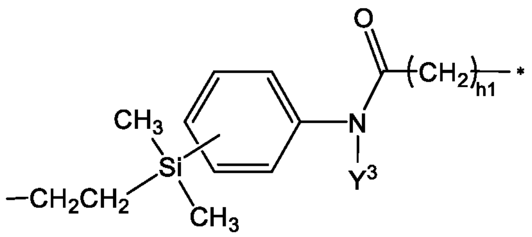

(43A)

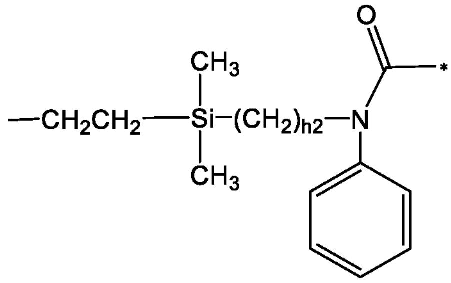

(43B)

wherein $Y^3$ is a hydrogen atom, a methyl group, an ethyl group or a phenyl group, h1 is 0 or 1, and h2 is an integer of 1 to 6, and a bond with * represents bonding to a monovalent perfluoropolyether group having the general formula (5) (the same applies hereinafter).

Examples of such a divalent linking group include $-CH_2-*$, $-OCH_2-*$, $-(CH_2)_2OCH_2-*$, $-(CH_2)_3OCH_2-*$, $-(CH_2)_3-NH-CO-*$, $-(CH_2)_3-NCH_3-CO-*$, and groups having the following general formulas, and among them, $-(CH_2)_3OCH_2-*$, $-(CH_2)_3-NH-CO-*$, and groups having the following general formulas are preferable. In the formulas below, Me represents a methyl group.

[Chem. 18]

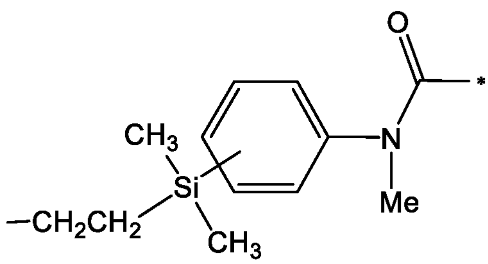

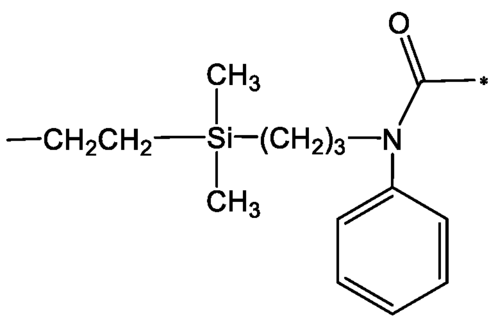

A siloxane skeleton of the fluorine-containing organohydrogenpolysiloxane compound of the component (B) may be cyclic, linear, or branched siloxane skeletons, but the component (B) is preferably a fluorine-containing organohydrogenpolysiloxane compound having a cyclic siloxane skeleton. In particular, as the fluorine-containing organohydrogenpolysiloxane compound of the component (B), a compound having the following general formula (4) can be used.

[Chem. 19]

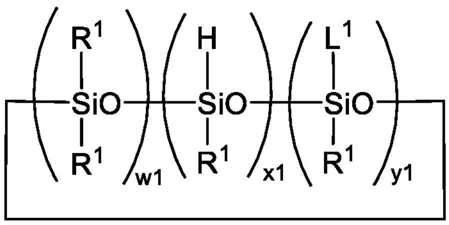

(4)

wherein $R^1$ is an unsubstituted or halogen-substituted monovalent hydrocarbon group, $L^1$ is a monovalent perfluoropolyether group having the general formula (5) which may be bonded to a silicon atom via the above-described divalent linking group, w1 is an integer of 0 to 50, and preferably an integer of 0 to 20, x1 is an integer of 2 to 50, and preferably an integer of 3 to 20, and y1 is an integer of 1 to 50, and preferably an integer of 1 to 20, w1 + x1 + y1 is an integer satisfying a numerical average molecular weight of 1,000 to 4,000 as described above, preferably $3 \leq w1 + x1 + y1 \leq 53$, more preferably $4 \leq w1 + x1 + y1 \leq 20$, and further preferably $4 \leq w1 + x1 + y1 \leq 10$, and the repeating units in parentheses may be randomly arranged.

The unsubstituted or halogen-substituted monovalent hydrocarbon group of $R^1$ is preferably one having 1 to 10 carbon atoms, more preferably one having 1 to 8 carbon atoms, and specific examples include alkyl groups such as a methyl group, an ethyl group, a propyl group, a butyl group, a hexyl group, a cyclohexyl group, and an octyl group; aryl groups such as a phenyl group and a tolyl group; aralkyl groups such as a benzyl group and a phenylethyl group; and the like, and substituted monovalent hydrocarbon groups in which some or all of hydrogen atoms of these groups are substituted with halogen atoms such as fluorine, and the like, and among them, a methyl group is particularly preferable.

The numerical average molecular weight of the component (B) can be calculated by $^1$H-NMR and $^{19}$F-NMR measurement. When the structure of each constituent part in parentheses in the general formula (4) and the structural unit contained in the general formula (5) are clear, the numerical average molecular weight can be calculated from the integrated value of each constituent part in parentheses having the general formula (4) and the integrated value of each repeating unit having the general formula (5) by performing $^1$H-NMR measurement and $^{19}$F-NMR measurement of the compound having the general formula (5).

Preferable examples of the component (B) having such a fluorine-containing organic group include the following compounds. In the formulas below, Me represents a methyl group.

[Chem. 20]

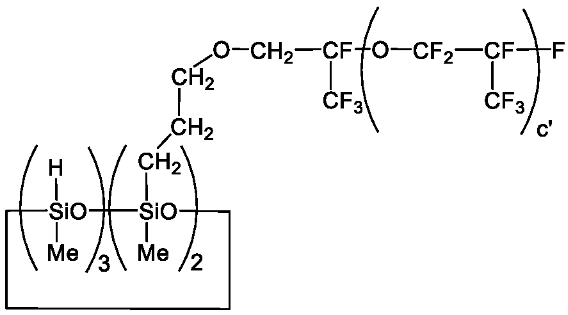

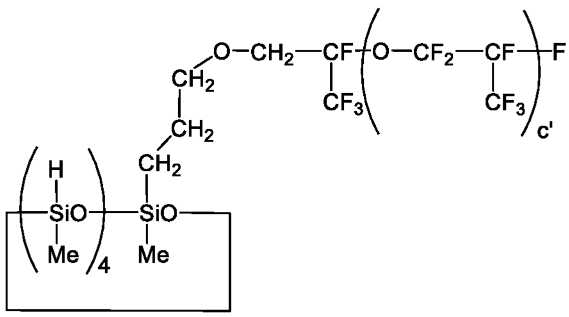

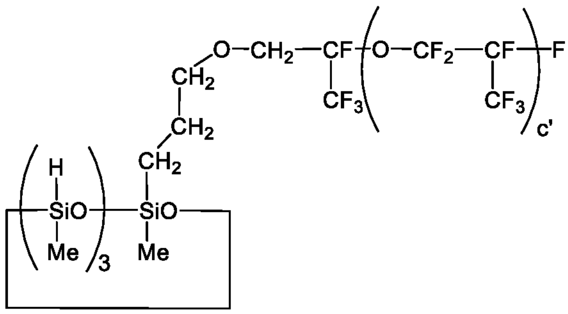

wherein c' is an integer of 4 to 20.

[Chem. 21]

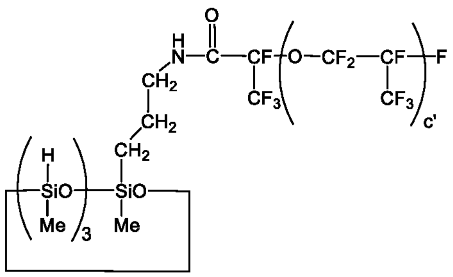

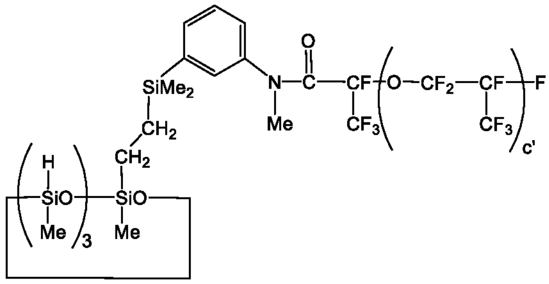

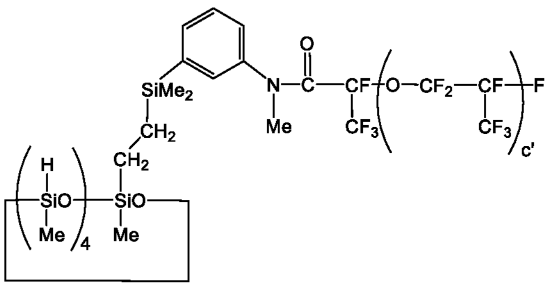

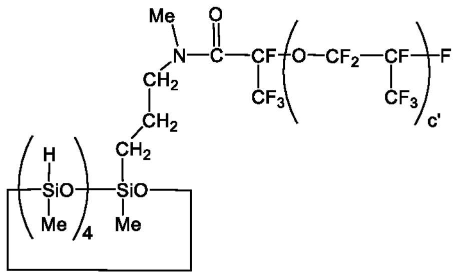

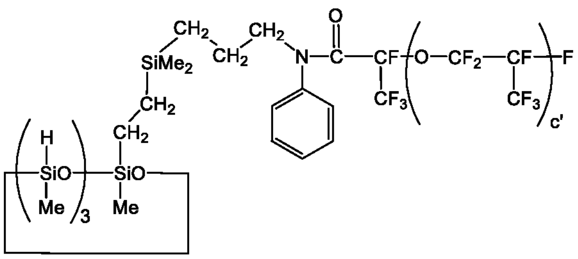

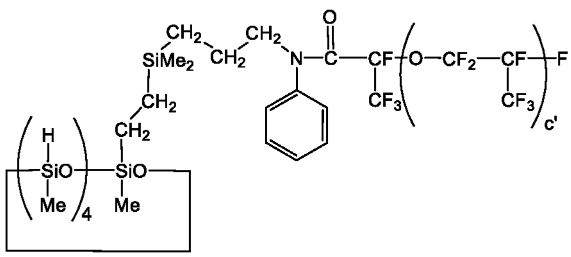

wherein c' is an integer of 4 to 20.

The amount of Si-H groups in the component (B) is preferably 0.05 to 0.8 mol/100 g, and particularly preferably 0.1 to 0.6 mol/100 g.

The compounding amount of the component (B) is an effective amount for curing the component (A), and is usually an amount to give 0.1 to 2.5 mol, preferably 0.2 to 2 mol of hydrosilyl groups, i.e., the Si-H groups in the component (B) per mol of alkenyl groups such as vinyl groups, allyl groups, or cycloalkenyl groups contained in the component (A). When the amount of the hydrosilyl group (≡Si-H group) is too small, the degree of crosslinking becomes insufficient, and as a result, a cured product may not be obtained, and when the amount is too large, foaming may occur during curing.

The total amount of Si-H groups of the component (B) and the component (D) described later is usually an amount to give 0.105 to 4 mol, preferably 0.21 to 3 mol, and more preferably 0.41 to 2.5 mol per mol of alkenyl groups in the component (A).

In the composition of the present invention, a fluorine-containing organohydrogenpolysiloxane compound having the above weight loss ratio of 20% or less is used as the fluorine-containing organohydrogenpolysiloxane compound of the component (B) that acts as a crosslinking agent or a chain length extender for the component (A). As a preferred embodiment, a cyclic fluorine-containing organohydrogenpolysiloxane compound having the above weight loss ratio of 15% or less and a fluorine-containing organohydrogenpolysiloxane compound having a linear siloxane structure having the above weight loss ratio of more than 15% (the above weight loss ratio of preferably about 16 to 20%, more preferably about 16 to 18%) can be used in combination at a ratio of the same mass or less (100 wt% or less), particularly 75 wt% or less (0 to 75 wt%), or further 55 wt% or less (0 to 55 wt%) with respect to the cyclic fluorine-containing organohydrogenpolysiloxane compound having the above weight loss ratio of 15% or less. This fluorine-containing organohydrogenpolysiloxane compound having a linear siloxane structure is also clearly distinguished from the organohydrogenpolysiloxane compound which is an adhesive property-imparting agent of the component (D) described later in that the fluorine-containing organohydrogenpolysiloxane compound does not have a functional group capable of contributing to adhesive property such as an epoxy group and a trialkoxysilyl group in the molecule. Preferable examples of the fluorine-containing

organohydrogenpolysiloxane compound having a linear siloxane structure include the compounds shown below. In the formulas below, Me represents a methyl group.

[Chem. 22]

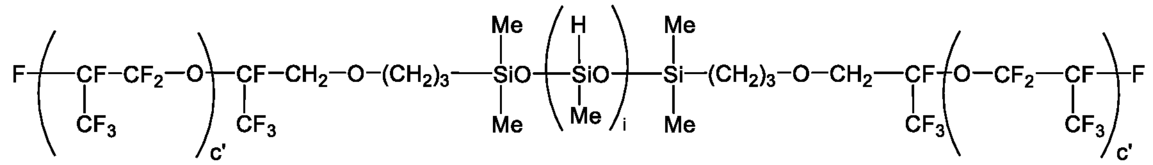

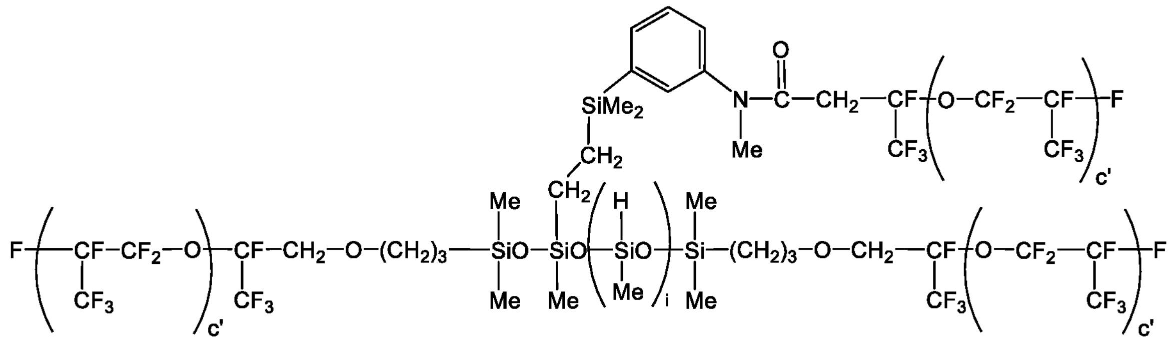

wherein i is an integer of 3 to 20 and c' is an integer of 2 to 20.

The component (B) can be used alone or in combination of two or more kinds thereof. The fluorine-containing organohydrogenpolysiloxane compound of the component (B) is clearly distinguished from the organohydrogenpolysiloxane compound which is an adhesive property-imparting agent of the component (D) described later in that the fluorine-containing organohydrogenpolysiloxane compound does not have a functional group capable of contributing to adhesive property such as an epoxy group and a trialkoxysilyl group in the molecule.

[Component (C)]

The component (C) used in the adhesive composition of the present invention is a platinum group metal compound. This is a hydrosilylation reaction catalyst, and is a catalyst that promotes an addition reaction between an alkenyl group in the component (A) and a hydrosilyl group in the components (B) and (D). This hydrosilylation reaction catalyst is generally a compound of a noble metal, and platinum or a platinum compound which is relatively easily available is often used because of its high price.

Examples of the platinum compound include chloroplatinic acid, or complexes of chloroplatinic acid with an olefin such as ethylene, complexes with alcohol or vinylsiloxane, metallic platinum supported on silica, alumina, carbon, or the like, and the like. As platinum group metal compounds other than platinum compounds, rhodium, ruthenium, iridium, and palladium-based compounds are also known, and examples thereof include $RhCl(PPh_3)_3$, $RhCl(CO)(PPh_3)_2$, $Ru_3(CO)_{12}$, $IrCl(CO)(PPh_3)_2$, $Pd(PPh_3)_4$, and the like. In the formulas, Ph is a phenyl group.

In the use as these catalysts, a catalyst can be used in a solid state when the catalyst is a solid catalyst, but in order to obtain a more uniform cured product, for example, it is preferable to use a catalyst obtained by dissolving chloroplatinic acid or a complex in an appropriate solvent, and compatibilizing the solution with the linear perfluoropolyether compound as the component (A).

The use amount of the component (C) may be a catalytic amount, but for example, it is preferable to blend 0.1 to 1,000 ppm (in terms of platinum group metal atom) with respect to the mass of the component (A), and it is more preferable to blend 1 to 500 ppm. The component (C) can be used alone or in combination of two or more kinds thereof.

[Component (D)]

The component (D) used in the adhesive composition of the present invention is an organohydrogenpolysiloxane compound that acts as an adhesiveness improver for sufficiently exhibiting self-adhesive property to the composition of the present invention by blending the component (D), and has one or more hydrogen atoms bonded to silicon atoms

(Si-H groups) and one or more epoxy groups and/or trialkoxysilyl groups bonded to silicon atoms via a carbon atom or a carbon atom and an oxygen atom in one molecule, and having a numerical average molecular weight of 700 or more.

The component (D) is more preferably one further having one or more monovalent perfluoroalkyl groups or monovalent perfluoropolyether groups (perfluorooxyalkyl groups) bonded to silicon atoms via a divalent linking group containing at least one selected from a nitrogen atom, a carbon atom, and an oxygen atom in one molecule, preferably bonded to silicon atoms via a divalent linking group containing a nitrogen atom and a carbon atom, or bonded to silicon atoms via a divalent linking group containing a nitrogen atom, a carbon atom, and an oxygen atom. Such a monovalent perfluoroalkyl group or monovalent perfluoropolyether group may be the same as those shown in the component (B), and the monovalent perfluoroalkyl group or a divalent linking group linking the monovalent perfluoropolyether group and a silicon atom may also be the same as those shown in the component (B).

The component (D) has a numerical average molecular weight of preferably 700 to 4,000, and more preferably 900 to 2,000. When the organohydrogenpolysiloxane compound having a numerical average molecular weight of less than 700 is present in the adhesive composition, the organohydrogenpolysiloxane compound itself may volatilize as an outgas during heat curing and cause contamination, and it may be difficult to blend a sufficient amount for exhibiting self-adhesive property to various substrates, which is not preferable. On the other hand, the organosiloxane having a numerical average molecular weight of more than 4,000 is not preferable because the viscosity increases so much that blending becomes difficult.

A siloxane skeleton of the organohydrogenpolysiloxane compound of the component (D) may be cyclic, linear, branched, or the like, or may be in a mixed form of two or more thereof.

As the organohydrogenpolysiloxane compound of the component (D), compounds having the following general formulas can be used.

[Chem. 23]

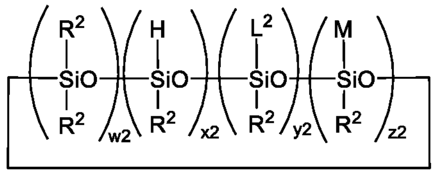

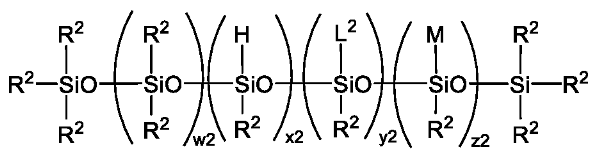

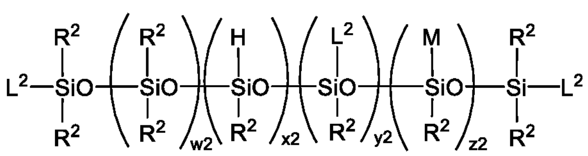

wherein $R^2$ is an unsubstituted or halogen-substituted monovalent hydrocarbon group, $L^2$ is a monovalent perfluoropolyether group bonded to a silicon atom via a divalent linking group shown below, and M is an epoxy group or a trialkoxysilyl group bonded to a silicon atom via a carbon atom or a carbon atom and an oxygen atom shown below, w2 is preferably an integer satisfying $0 \leq w2 \leq 50$, and more preferably an integer satisfying $0 \leq w2 \leq 20$, x2 is preferably an integer satisfying $1 \leq x2 \leq 50$, and more preferably an integer satisfying $1 \leq x2 \leq 20$, y2 is preferably an integer satisfying $0 \leq y2 \leq 50$, and more preferably an integer satisfying $1 \leq y2 \leq 20$, and z2 is preferably an integer satisfying $1 \leq z2 \leq 50$, and more preferably an integer satisfying $1 \leq z2 \leq 20$, $w2 + x2 + y2 + z2$ is an integer satisfying a numerical average molecular weight of 700 to 4,000 as described above, and the repeating units in parentheses may be randomly arranged.

The unsubstituted or halogen-substituted monovalent hydrocarbon group of $R^2$ is preferably one that is free of an aliphatic unsaturated bond having 1 to 10 carbon atoms, more preferably one having 1 to 8 carbon atoms, and specific examples include alkyl groups such as a methyl group, an ethyl group, a propyl group, a butyl group, a hexyl group, a cyclohexyl group, and an octyl group; aryl groups such as a phenyl group and a tolyl group; aralkyl groups such as a

benzyl group and a phenylethyl group; and the like, and substituted monovalent hydrocarbon groups in which some or all of hydrogen atoms of these groups are substituted with halogen atoms such as fluorine, and the like, and among them, a methyl group is particularly preferable.

$L^2$ is a monovalent perfluoropolyether group bonded to a silicon atom via a divalent linking group, and is preferably one having the following general formula (44).

$$-Z-Rf^3 \qquad (44)$$

wherein Z is any group selected from divalent organic groups having 1 to 6 carbon atoms which may be bonded via an ether bond or an amide bond, groups having the following general formula (45), and groups having the general formula (46),

[Chem. 24]

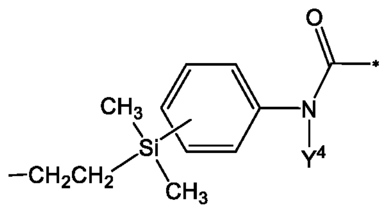

(45)

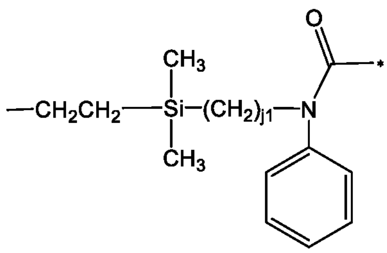

(46)

wherein $Y^4$ is a hydrogen atom, a methyl group, an ethyl group, or a phenyl group, and j 1 is an integer of 1 to 6, a bond with * represents bonding to a monovalent perfluoropolyether group (the same applies hereinafter), and $Rf^3$ is a monovalent perfluoropolyether group.

Examples of Z include groups having $-CH_2-*$, $-OCH_2-*$, $-CH_2OCH_2-*$, $-(CH_2)_2OCH_2-*$, $-(CH_2)_3OCH_2-*$, $-CH_2-NH-CO-*$, $-(CH_2)_3-NH-CO-*$, and the following general formulas (45A), (45B), and (46A), and among them, a group having $-(CH_2)_3OCH_2-*$, $-(CH_2)_3-NH-CO-*$, general formula (45A), (45B), or (46A) is preferable. In the formulas below, Me represents a methyl group.

[Chem. 25]

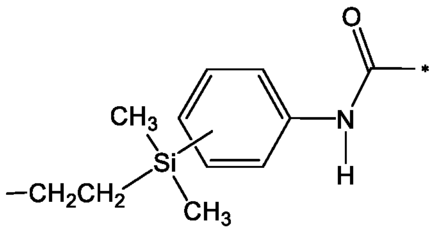

(45A)

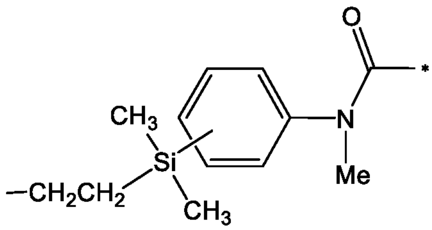

(45B)

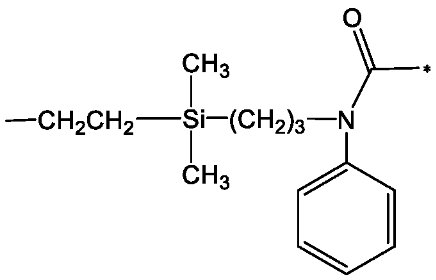

(46A)

In the general formula (44), $Rf^3$ is a monovalent perfluoropolyether group, and has the following general formula (47):

$$E1\text{-}(C_4F_8O)_{c1}\text{-}(C_3F_6O)_{d1}\text{-}(C_2F_4O)_{e1}\text{-}(CF_2O)_{f1}\text{-}C_{g1}F_{2g1}\text{-} \quad (47)$$

wherein E1 is a fluorine atom or a perfluorooxyalkyl group having 1 to 6 carbon atoms, c1, d1, e1, and f1 are each independently an integer of 0 to 20, and 2 <_ c1 + d1 + e1 + f1 ≤ 20, g1 is an integer of 1 to 3, and the repeating units in parentheses may be randomly arranged.

Examples of the monovalent perfluoropolyether group having the general formula (47) include the following:

[Chem. 26]

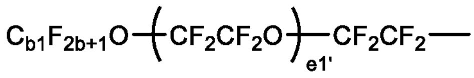
(48)

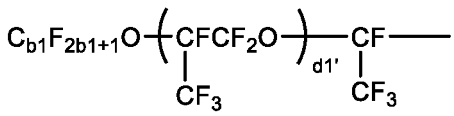
(49)

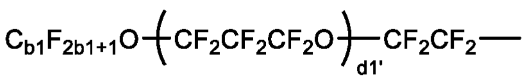
(50)

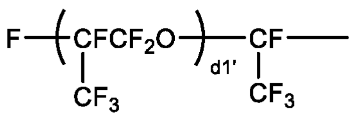
(51)

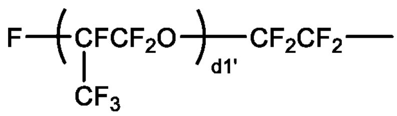
(52)

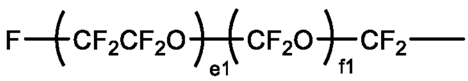
(53)

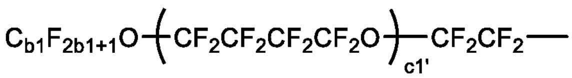
(54)

wherein b1 is an integer of 1 to 6, e1' is an integer of 2 to 20 in the formula (48), d1' is an integer of 2 to 20 in the formulas (49) to (52), e1 and f1 are each an integer of 0 to 20 and e1 + f1 is 2 to 20 in the formula (53), and c1' is an integer of 2 to 20 in the formula (54).

M represents an epoxy group or a trialkoxysilyl group bonded to a silicon atom via a carbon atom or a carbon atom and an oxygen atom, and specific examples thereof include the following groups:

[Chem. 27]

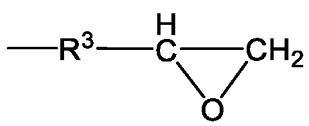

wherein $R^3$ represents a divalent hydrocarbon group having 1 to 10 carbon atoms, particularly 1 to 5 carbon atoms, in which an oxygen atom may be interposed (an alkylene group such as a methylene group, an ethylene group, or a propylene group, a cycloalkylene group such as a cyclohexylene group, an oxyalkylene group such as an oxyethylene group, an oxypropylene group, or an oxybutylene group, or the like, preferably $-(CH_2)_3OCH_2-*'$ (a bond with *' represents bonding to an epoxy group).

$-R^4-Si(OR^5)_3$

wherein $R^4$ represents a divalent hydrocarbon group having 1 to 10 carbon atoms, particularly 1 to 4 carbon atoms (an alkylene group such as a methylene group, an ethylene group, or a propylene group, or the like), and $R^5$s independently represent a monovalent hydrocarbon group having 1 to 8 carbon atoms, particularly 1 to 4 carbon atoms (an alkyl group such as a methyl group, an ethyl group, a propyl group, or a butyl group, or the like).

[Chem. 28]

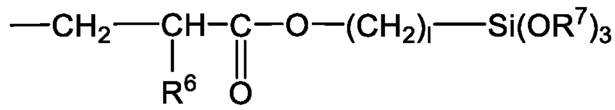

wherein $R^6$ is a hydrogen atom or a methyl group, $R^7$s independently represent a monovalent hydrocarbon group having 1 to 8 carbon atoms, particularly 1 to 4 carbon atoms (an alkyl group such as a methyl group, an ethyl group, a propyl group, or a butyl group, or the like), and 1 represents an integer of 2 to 10.

The numerical average molecular weight of the component (D) can be calculated by $^{1}$H-NMR and $^{19}$F-NMR measurement. When the structure of each constituent part in parentheses in the general formula representing the component (D) and the structural unit contained in the general formula (5) are clear, the numerical average molecular weight can be calculated from the integrated value of each constituent part in parentheses in the general formula representing the component (D) and the integrated value of each repeating unit having the general formula (5) by performing $^{1}$H-NMR measurement and $^{19}$F-NMR measurement.

The organohydrogenpolysiloxane compound of the component (D) can be obtained by subjecting a compound containing an aliphatic unsaturated group such as a vinyl group or an allyl group and an epoxy group and/or a trialkoxysilyl group in an organohydrogenpolysiloxane having three or more hydrogen atoms bonded to silicon atoms (Si-H groups) in one molecule, and further a compound containing an aliphatic unsaturated group and a perfluoroalkyl group or a perfluorooxyalkyl group as necessary, to a partial addition reaction according to a conventional method. The number of the aliphatic unsaturated groups needs to be smaller than the number of Si-H groups.

In the production of the organohydrogenpolysiloxane compound of the component (D), the target substance may be isolated after completion of the reaction, but a mixture obtained by simply removing the unreacted product and the addition reaction catalyst can also be used.

Specific examples of the organohydrogenpolysiloxane compound of the component (D) include those having the following structural formulas. These compounds may be used singly or in combination of two or more kinds thereof. In the formulas below, Me represents a methyl group.

[Chem. 29]

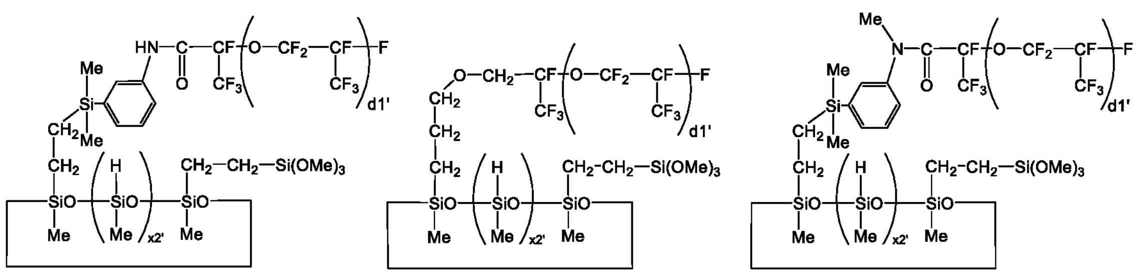

wherein x2' is 2 or 3, and d1' is an integer of 2 to 20.

[Chem. 30]

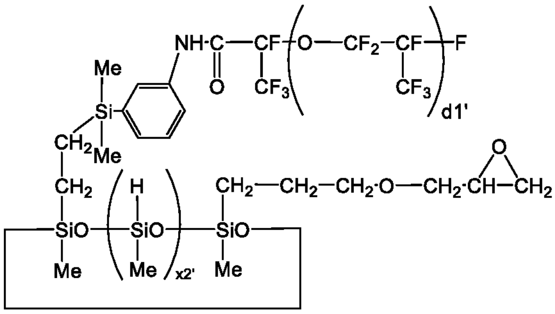

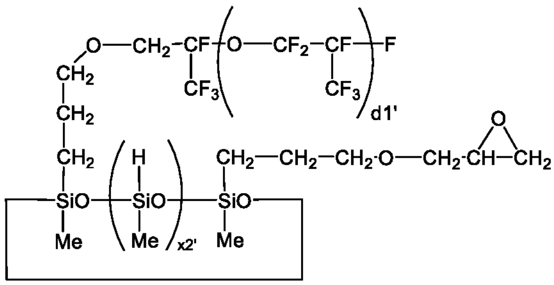

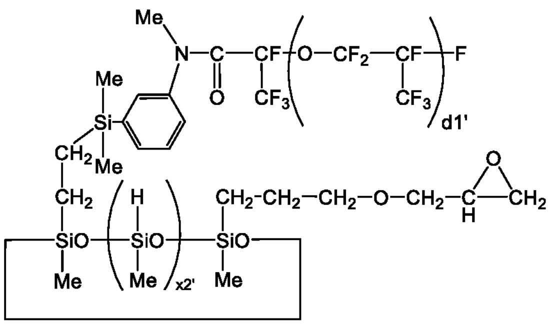

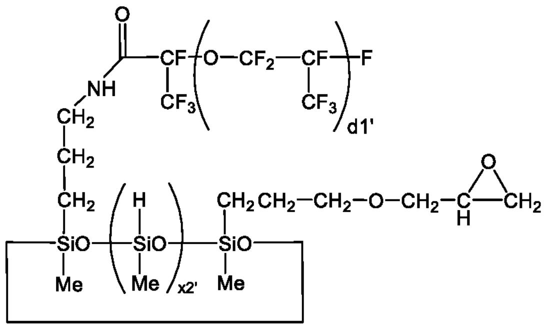

wherein x2' is 2 or 3, and d1' is an integer of 2 to 20.

[Chem. 31]

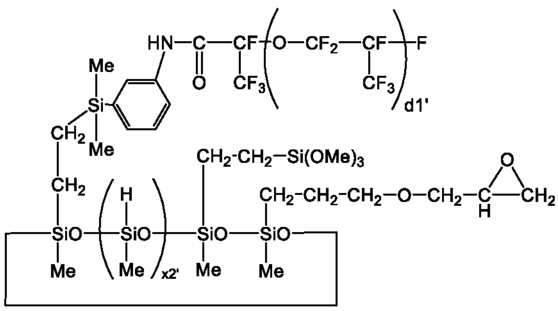

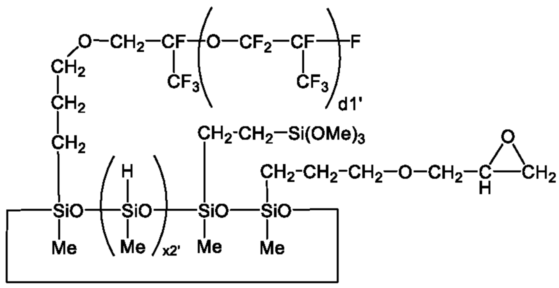

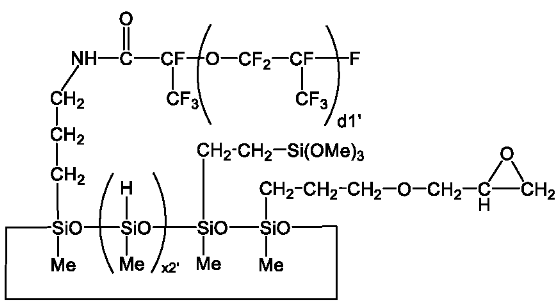

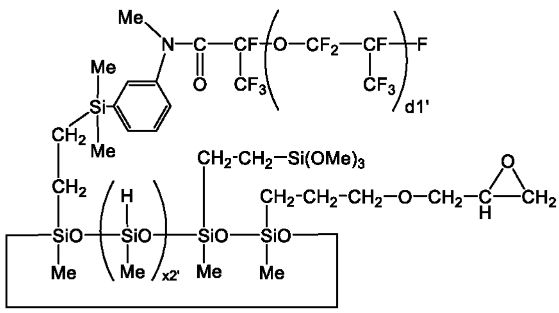

wherein x2' is 1 or 2, and d1' is an integer of 2 to 20.

[Chem. 32]

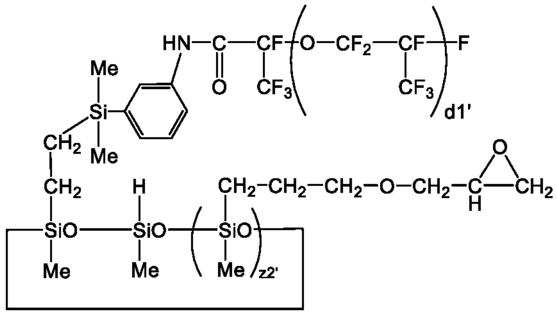
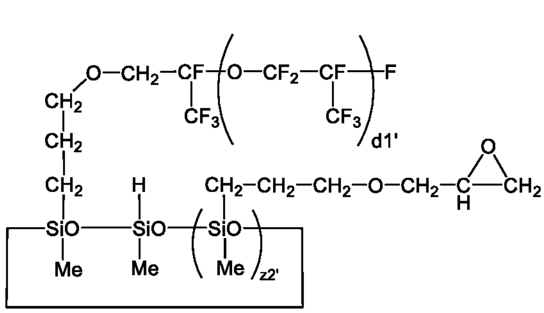
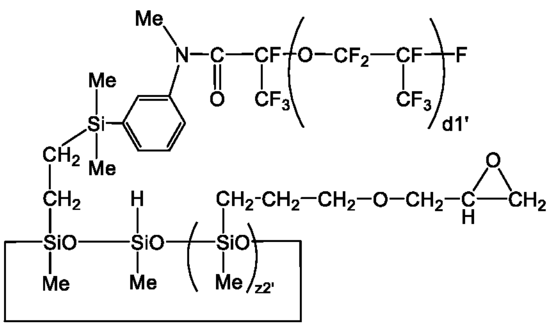
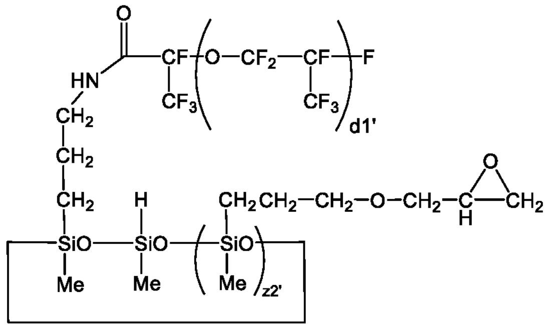

wherein z2' is 2 or 3, and d1' is an integer of 2 to 20.

[Chem. 33]

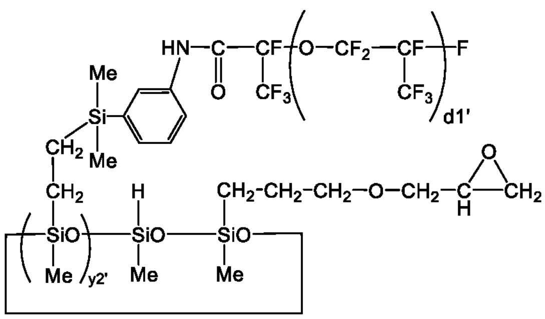
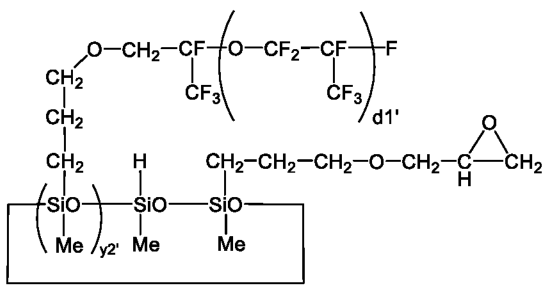
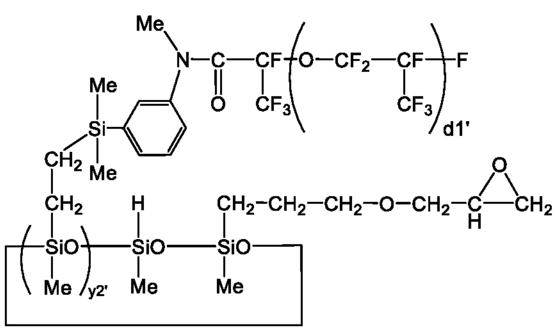
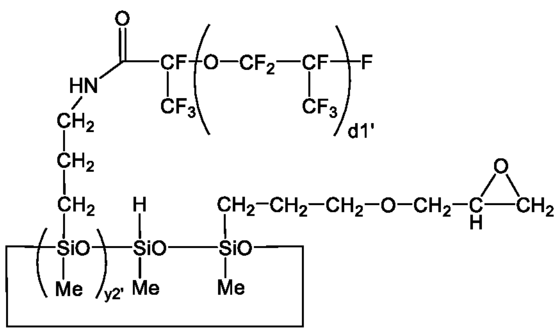

wherein y2' is 2 or 3, and d1' is an integer of 2 to 20.

The amount of Si-H groups in the component (D) is preferably 0.06 to 0.6 mol/100 g.

The compounding amount of the component (D) is an amount to give 0.005 to 1.5 mol, preferably 0.01 to 1.0 mol, and more preferably 0.05 to 0.5 mol of hydrogen atoms bonded to silicon atoms in the component (D) per mol of alkenyl groups in the component (A). When the amount of the hydrogen atoms bonded to silicon atoms in the component (D) is less than 0.005 mol per mol of alkenyl groups in the component (A), sufficient adhesive property cannot be obtained, and when the amount of the hydrogen atoms bonded to silicon atoms in the component (D) exceeds 1.5 mol per mol of alkenyl groups in the component (A), the fluidity of the composition is deteriorated, physical strength of the resulting cured product is lowered, and curability is often inhibited, which is not preferable.

[Component (E)]

The component (E) is a carboxylic anhydride, and is an optional component for improving the adhesion-imparting ability of the component (D) and promoting the exhibition of self-adhesive property of a cured product obtained by curing the composition of the present invention. As the component, one used as a curing agent for an epoxy resin can be used.

Examples of the carboxylic anhydride of the component (E) include carboxylic anhydrides which are solid at 23°C. Specific examples thereof include the following compounds. In the formulas below, Me represents a methyl group.

[Chem. 34]

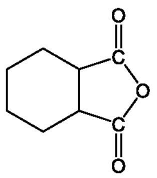
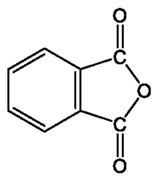
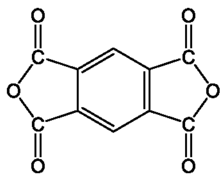
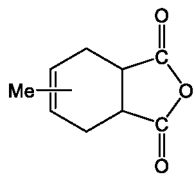

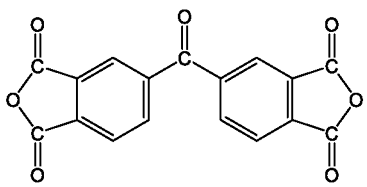
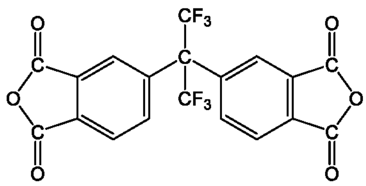

The carboxylic anhydride as the component (E) may be a cyclic organopolysiloxane having a hydrogen atom directly linked to a silicon atom in one molecule, a monovalent perfluoroalkyl group or monovalent perfluorooxyalkyl group bonded to a silicon atom via a divalent hydrocarbon group which may have an oxygen atom or a nitrogen atom, and a cyclic carboxylic anhydride residue bonded to a silicon atom via a divalent hydrocarbon group (that is, a fluorine-containing organopolysiloxane-modified carboxylic anhydride compound) having the following general formula:

[Chem. 35]

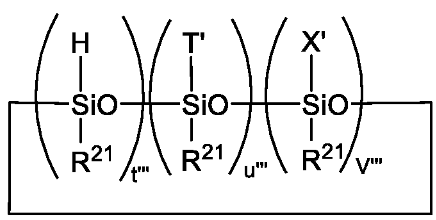

In the formula, T' is a monovalent perfluoropolyether group bonded to a silicon atom via a divalent hydrocarbon group which may have an oxygen atom or a nitrogen atom, and examples thereof include the same group as $L^1$ of the component (B). These are groups introduced from the viewpoint of compatibility with the component (A), dispersibility, uniformity after curing, and the like.

In addition, $R^{21}$ is an unsubstituted or substituted monovalent hydrocarbon group, and examples thereof include the same group as $R^1$ described above, and a methyl group and an ethyl group are preferable.

Furthermore, t‴ is an integer of 1 to 6, preferably an integer of 2 to 5, u‴ is an integer of 1 to 4, preferably an integer of 1 to 3, v‴ is an integer of 1 to 4, preferably an integer of 1 to 3, and t‴ + u‴ + v‴ is an integer of 4 to 10, preferably an integer of 4 to 8. However, the arrangement order of the ((H)($R^{21}$)SiO) unit, the ((T')($R^{21}$)SiO) unit, and

the ((X')($R^{21}$)SiO) unit is random.

Also, examples of the divalent hydrocarbon group which may have an oxygen atom or a nitrogen atom and connects the monovalent perfluoroalkyl group or the monovalent perfluorooxyalkyl group to a silicon atom include the same groups as the exemplified divalent linking groups in the component (B).

Further, X' is a cyclic carboxylic anhydride residue bonded to a silicon atom via a divalent hydrocarbon group, and specific examples thereof include groups having the following general formula.

[Chem. 36]

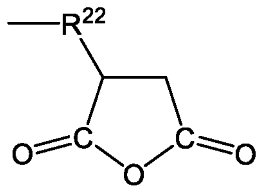

In the formula, $R^{22}$ is a divalent hydrocarbon group having 2 to 15 carbon atoms. Specific examples thereof include an ethylene group, a propylene group, a butylene group, and the like, and among them, a propylene group is preferable.

Examples of the cyclic organopolysiloxane having the above general formula include the following compounds. In the formulas below, Me represents a methyl group.

[Chem. 37]

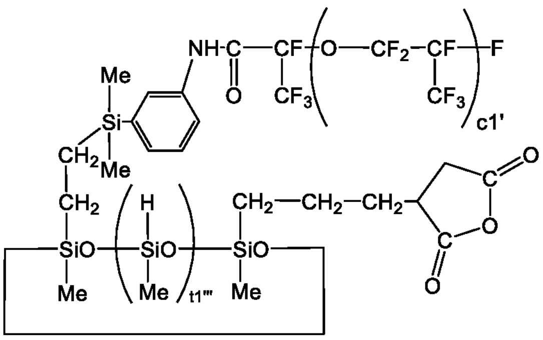

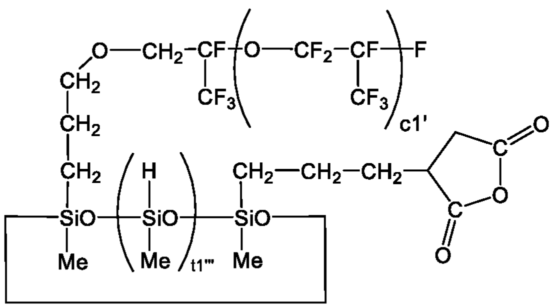

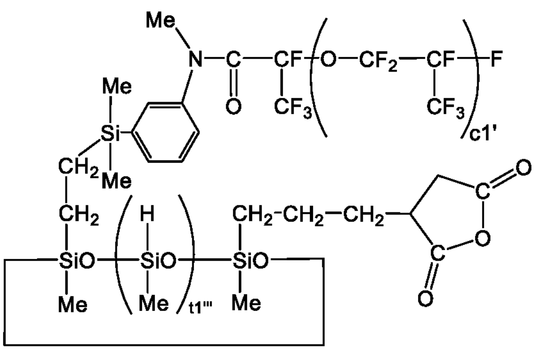

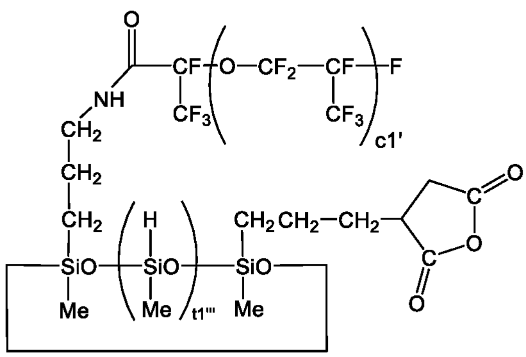

wherein t1''' is 2 or 3, and c1' is an integer of 2 to 20.

[Chem. 38]

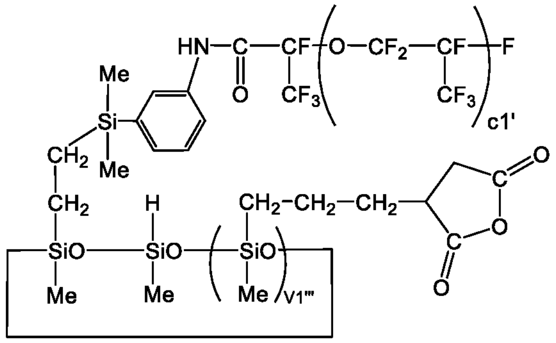

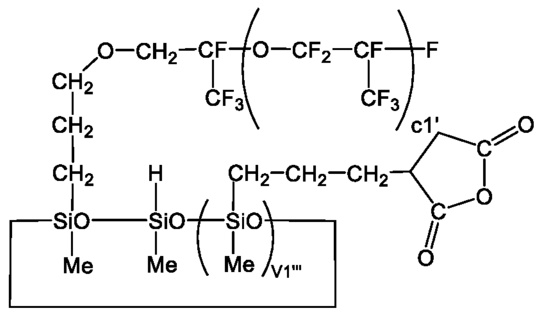

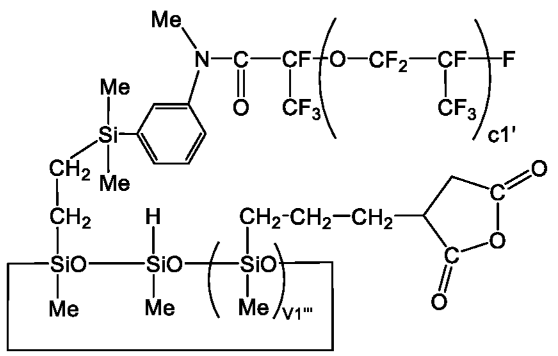

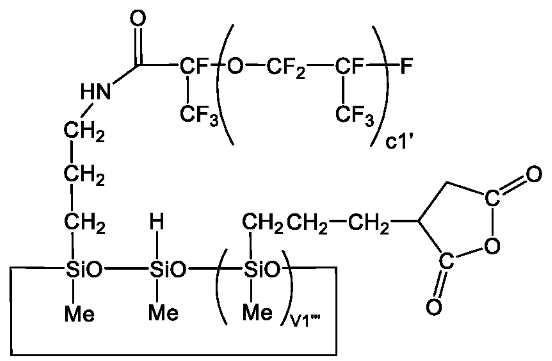

wherein V1‴ is 2 or 3, and c1' is an integer of 2 to 20.

These components (E) may be used alone or two or more kinds thereof may be used in combination. At that time, the carboxylic anhydride that is solid at 23°C and the cyclic organopolysiloxane (fluorine-containing organopolysiloxane-modified carboxylic anhydride compound) may be used in combination.

The compounding amount of the component (E) is 0.010 to 10 parts by weight and preferably 0.10 to 2 parts by weight, per 100 parts by weight of the component (A). When the compounding amount is 0.010 parts by weight or more, a sufficient effect for promoting the exhibition of adhesive property of the composition of the present invention is obtained, which is preferable. On the other hand, when the compounding amount is 10 parts by weight or less, the fluidity of the composition of the present invention is improved, and storage stability of the composition is obtained, which is preferable.

[Component (F) (Other components)]

In the adhesive composition of the present invention, in order to enhance its practicality, in addition to the above-described components (A) to (E), various compounding agents such as a plasticizer, a viscosity modifier, a flexibility imparting agent, a control agent for hydrosilylation reaction catalyst, an inorganic filler, an adhesion promoter, an adhesion additive other than the component (D), and a silane coupling agent can be added as necessary. The compounding amounts of these additives are arbitrary as long as the object of the present invention is not impaired, and the properties of the composition and the physical properties of the cured product are not impaired.

As the plasticizer, viscosity modifier, and flexibility imparting agent, a polyfluoromonoalkenyl compound having the following general formula (55) and/or a linear polyfluoro compound having the following general formula (56) or (57) can be used in combination. These compounds have a numerical average molecular weight of preferably 3,000 to 20,000.

$$Rf^4\text{-}(X')_{p'}CH{=}CH_2 \qquad (55)$$

wherein X' is the same as Z (divalent linking group) in the $L^2$ structure, p' is 0 or 1, and $Rf^4$ is a monovalent

perfluoropolyether group having the following general formula:

[Chem. 39]

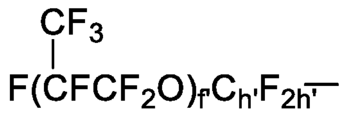

wherein f' is an integer of 2 to 200, preferably an integer of 2 to 100, h' is an integer of 1 to 3, and the sum of f' and h' is smaller than the sum of p and q in $Rf^1$ of the linear perfluoropolyether compound having the general formula (1).

$$Y^5\text{-O-}(CF_2CF_2CF_2O)_{c2}\text{-}Y^5 \qquad (56)$$

wherein $Y^5$ is independently a group having the formula: $C_{k'}F_{2k'+1}$- (k' is an integer of 1 to 3), c2 is an integer of 1 to 200 and is smaller than z in $Rf^1$ of the linear perfluoropolyether compound having the general formula (1).

$$Y^6\text{-O-}(CF_2O)_{d2}(CF_2CF_2O)_{e2}\text{-}Y^6 \qquad (57)$$

wherein $Y^6$ is the same as $Y^5$, d2 and e2 are each an integer of 1 to 200, and the sum of d2 and e2 is smaller than the sum of n and m in $Rf^1$ of the linear perfluoropolyether compound having the general formula (1), and the repeating units in parentheses may be randomly arranged.

Specific examples of the polyfluoromonoalkenyl compound having the general formula (55) include, for example, the following. Note that the following m' satisfies the above requirement.

[Chem. 40]

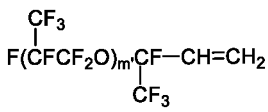

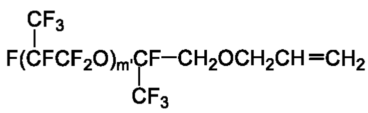

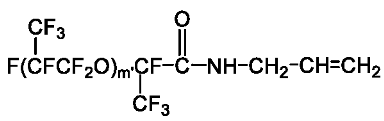

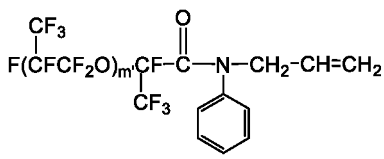

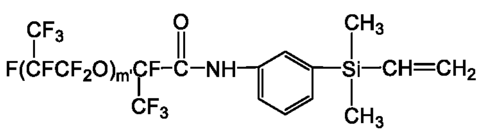

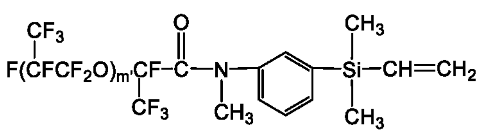

Specific examples of the linear polyfluoro compound having the general formula (56) or (57) include, for example, the following. Note that the sum of c2, d2, e2, and d2 and e2 below satisfies the above requirement.

$$CF_3O\text{-}(CF_2CF_2CF_2O)_{c2}\text{-}CF_2CF_3$$

$$CF_3\text{-}(OCF_2CF_2)_{e2}(OCF_2)_{d2}\text{-}O\text{-}CF_3$$

The compounding amount of the polyfluoro compound having the formula (55), (56), or (57) is 1 to 300 parts by weight and preferably 50 to 250 parts by weight, per 100 parts by weight of the component (A). Also, the viscosity (23°C) is desirably in the range of 2,000 to 50,000 mPa·s.

Further, examples of the control agent for hydrosilylation reaction catalyst include acetylenic alcohols such as ethynylcyclohexanol (also referred to as 1-ethynyl-1-hydroxycyclohexane), 3-methyl-1-butin-3-ol, 3,5-dimethyl-1-hexin-3-ol, 3-methyl-1-penten-3-ol, and phenylbutinol, reaction products of chlorosilane having the monovalent fluorine-containing substituent with an acetylenic alcohol, 3-methyl-3-penten-1-yne, 3,5-dimethyl-3-hexen-1-yne, triallyl isocyanurate, or polyvinylsiloxane, organophosphorus compounds, and the like, and the addition thereof can appropriately maintain curing reactivity and storage stability.

As the inorganic filler, for example, reinforcing or quasi-reinforcing fillers such as quartz powder, fused quartz powder, diatomaceous earth, and calcium carbonate, inorganic pigments such as titanium oxide, iron oxide, carbon black, and cobalt aluminate, heat resistance improvers such as titanium oxide, iron oxide, carbon black, cerium oxide, cerium hydroxide, zinc carbonate, magnesium carbonate, and manganese carbonate, thermal conductivity imparting agents such as alumina, boron nitride, silicon carbide, and metal powder, conductivity imparting agents such as carbon black, silver powder, and conductive zinc flower, and the like can be added.

In addition, an adhesion promoter such as a carboxylic anhydride or a titanic acid ester, an adhesion imparting agent other than the component (D), and/or a silane coupling agent can be added.

[Method for producing adhesive composition]

The adhesive composition of the present invention can be produced by uniformly mixing the components (A) to (D) and other optional components using a mixing device such as a planetary mixer, a loss mixer, or a Hobart mixer, and a kneading device such as a kneader or a three-roll as necessary.

The method for producing the adhesive composition of the present invention is not particularly limited, and the adhesive agent composition can be produced by kneading the above components. In addition, a two-agent composition may be formed and mixed at the time of use.

The produced adhesive composition can be cured at room temperature depending on the type of the catalyst of the component (C), but it is preferable to heat the produced adhesive composition in order to promote the curing, and in particular, it is preferable to cure the adhesive composition at 60°C or more, preferably at 100 to 200°C for about several minutes to several hours in order to exhibit good adhesive property to various substrates.

When the adhesive composition of the present invention is used, the composition may be dissolved at a desired concentration in an appropriate fluorine-based solvent, for example, 1,3-bis(trifluoromethyl)benzene, Fluorinert (manufactured by 3M), perfluorobutyl methyl ether, perfluorobutyl ethyl ether or the like as long as there is no influence of outgas during heat curing depending on the application and purpose of the adhesive agent composition, and used. In particular, it is preferable to use a solvent in thin film coating applications.

The adhesive composition of the present invention exhibits good adhesive property to a wide variety of substrates such as metals and plastics. Examples of such a metal include aluminum, stainless steel (SUS), nickel, chromium, copper, zinc, and alloys of two or more thereof, and examples of the plastic include epoxy resins, phenol resins, polyester resins such as PET (polyethylene terephthalate) resins and PBT (polybutylene terephthalate) resins, PC (polycarbonate) resins, PPS (polyphenylene sulfide) resins, PA (polyamide) resins, PI (polyimide) resins, LCP (liquid crystal polymer) resins, and the like. In this case, the thickness of the cured product of the adhesive composition of the present invention is preferably about 80 μm to 1 mm.

In addition, the adhesive composition of the present invention is useful as an adhesive agent for various electrical or electronic parts. For example, it can be suitably used as an adhesive agent for an ink jet printer, an adhesive agent/sealant for a printer head, a coating agent for a roller or a belt of a laser printer or a copying device, an adhesive sealing agent/coating agent for various circuit boards, a die attach material for manufacturing an in-vehicle sensor, and the like. Specifically, for example, a die attach material for an in-vehicle sensor including the adhesive composition of the present invention can be used, and a sealing agent or coating agent for protection for a printing or copying device including the adhesive composition of the present invention can be used. By using these, it is possible to manufacture an article for an in-vehicle sensor in which a sensor chip is fixed with a cured product of the adhesive composition of the present invention, or it is possible to manufacture a part for a printing or copying device in which a cured product of the adhesive

composition of the present invention is used as a seal or coating layer for protection.

EXAMPLES

Hereinafter, the present invention is described specifically with reference to Examples and Comparative Examples, but the present invention is not limited to the following Examples. In the following examples, parts represent parts by weight. Also, viscosity and adhesive force are measured values at 23°C (the viscosity was measured in accordance with a method based on rotational viscosity in a viscosity test defined in JIS K6249, and the adhesive force was measured in accordance with Adhesives - Determination of tensile lap-shear strength of rigid-to-rigid bonded assemblies in JIS K6850). The (numerical average) molecular weight of the compounds (58), (64), and (65) was determined as a numerical average molecular weight in terms of polystyrene in gel permeation chromatography (GPC) analysis using AK-225 (manufactured by Asahi Glass Co., Ltd.) as a fluorine-based solvent as a developing solvent. In addition, the (numerical average) molecular weights of the compounds (59), (60), (61), (63), (66), and (67) were calculated on the basis of the integrated value of each unit in the compound calculated from the spectra obtained by performing $^{1}H$-NMR measurement and $^{19}F$-NMR measurement. With regard to the vinyl group amount of the components (A), it was measured by infrared spectroscopy (IR) using a calibration curve for a component (A1), and it was measured by proton nuclear magnetic resonance spectroscopy ($^{1}H$-NMR) using an internal standard substance for components (A2), (A3), and (A4). In addition, the amounts of Si-H groups in the components (B) ((B1), (B2), (B')) and the components D ((D1), (D2)) were measured by proton nuclear magnetic resonance spectroscopy ($^{1}H$-NMR) using an internal standard substance.

Further, the weight loss ratio upon heating each of the following compounds at 150°C for 1 hour was determined by the following measurement method.

First, a tare of a clean aluminum dish (W1) was weighed using a precision balance (reading limit: 0.0001 mg), then, 1.5 g of a sample (compound) was collected in the aluminum dish, and a mass of the aluminum dish on which the sample was placed (W2) was weighed using the precision balance. Subsequently, the aluminum dish on which the sample was placed was left in a thermostat at 150°C for 1 hour, after the heating, the aluminum dish was taken out from the thermostat and cooled in a desiccator, and after the cooling, a mass of the aluminum dish on which the sample was placed (W3) was weighed using the precision balance. The weight loss ratio of this sample was determined from the following formula.

$$\{(W3 - W1)/(W2 - W1)\} \times 100 \text{ (unit: \%)}$$

W1: Mass of aluminum dish (g)
W2: Mass of aluminum dish + mass of sample before heating (g)
W3: Mass of aluminum dish + mass of sample after heating (g)

[Example 1]

To 100 parts of (A1) a polymer having the following formula (58) (numerical average molecular weight: 15,550, weight loss ratio: 0.5%, viscosity: 10,900 mPa·s, vinyl group amount: 0.012 mol/100 g), 0.033 parts of (C1) an ethanol solution of a platinum-divinyltetramethyldisiloxane complex (platinum concentration: 3.0 wt%), 0.25 parts of a 60 wt% toluene solution of ethynylcyclohexanol, 3.00 parts of (B1) a compound having the following formula (59) (numerical average molecular weight: 1,906, weight loss ratio: 7.0%, Si-H group amount: 0.16 mol/100 g), 1.52 parts of (B2) a compound having the following formula (60) (numerical average molecular weight: 1,720, weight loss ratio: 16.0%, Si-H group amount: 0.52 mol/100 g), and 2.00 parts of (D1) a compound having the following formula (61) (numerical average molecular weight: 990, Si-H group amount: 0.121 mol/100 g) were added and mixed to prepare an adhesive composition. In the formulas, Me represents a methyl group.

[Chem. 41]

(A1)

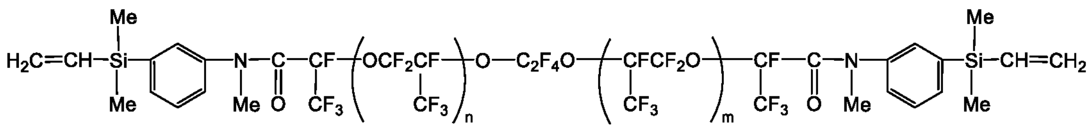

(58)

wherein m and n are integers of 1 or more, and the average value of m + n is 90.

[Chem. 42]

(B1)

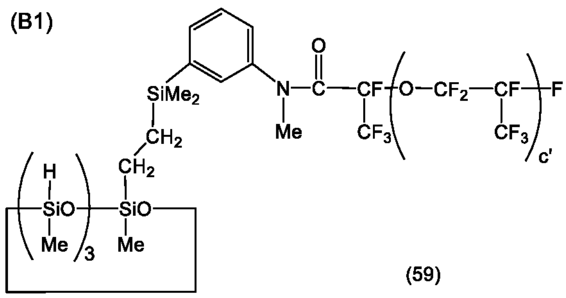

(59)

wherein the average value of c' is 8.

[Chem. 43]

(B2)

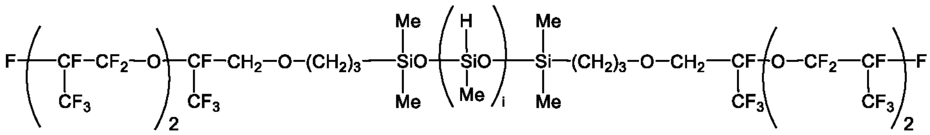

(60)

wherein the average value of i is 9.

[Chem. 44]

(D1)

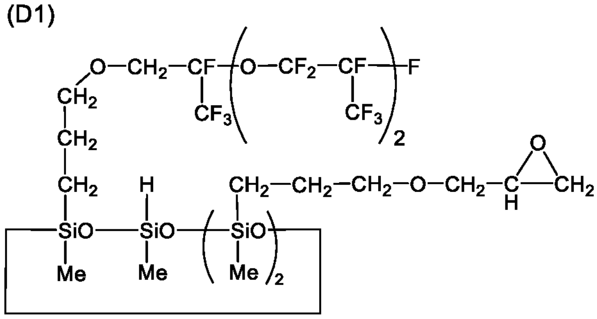

(61)

(Contamination confirmation test during heat curing)

Next, in order to confirm whether or not ambient contamination by outgas occurs during heat curing of this composition, the following experiment was performed.

Four sensor chips were prepared, and it was confirmed using a microscope that gold pads on the sensor chips were not contaminated (before the test). Thereafter, the sensor chips were placed in a clean glass petri dish, the glass petri dish was capped, and left in a thermostat at 150°C for 1 hour. After the heating, the glass petri dish was taken out from the thermostat and cooled in a desiccator for 3 hours. Thereafter, the sensor chips were taken out from the glass petri dish, and it was confirmed with a microscope that the gold pads were not contaminated in the same manner as before the sensor chips were left in the thermostat.

Next, 10 g of the adhesive composition of Example 1 and four sensor chips were arranged in a clean glass petri dish so as to be adjacent to each other, and after heating (leaving in the thermostat at 150°C for 1 hour) and cooling (cooling in the desiccator for 3 hours) according to the above method, the sensor chips after this test were taken out, and the degree of contamination of the gold pads was confirmed with a microscope. The results are shown in Table 1.

When outgas is generated during heat curing of the adhesive composition to contaminate the sensor chip, appearance defect (discoloration) due to adhesion of components of the outgas is confirmed. Therefore, if the appearance of the sensor chip is substantially similar to that of a blank, it can be said that contamination by outgas during heat curing of the composition has not occurred.

[Example 2]

An adhesive composition was prepared in the same manner as in Example 1 except that 0.2 parts of (E1) a compound having the following formula (62) was further added to 100 parts of (A1) the polymer having the formula (58) in Example 1. With respect to this adhesive composition, the same contamination confirmation test and evaluation during heat curing as in Example 1 were performed. The results are shown in Table 1.

[Chem. 45]

(E1)

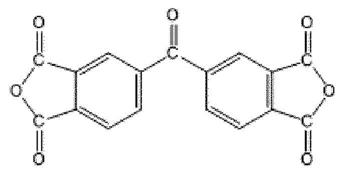

(62)

[Example 3]

100 Parts of (A1) the polymer having the formula (58) and 6.3 parts of fumed silica (Aerosil R-972 (trade name, manufactured by NIPPON AEROSIL CO., LTD.)) were kneaded at room temperature for 30 minutes using a planetary mixer, and further kneaded at 150°C for 1 hour under a reduced pressure of -98.0 kPaG. After cooling the kneaded product to room temperature, 0.033 parts of (C1) the ethanol solution of platinum-divinyltetramethyldisiloxane complex (platinum concentration: 3.0 wt%), 0.25 parts of the 60 wt% toluene solution of ethynylcyclohexanol, 3.00 parts of (B1) the compound having the formula (59), 1.52 parts of (B2) the compound having the formula (60), 2.00 parts of (D1) the compound having the formula (61), and 0.2 parts of (E1) the compound having the formula (62) were added and mixed to prepare an adhesive composition. With respect to this adhesive composition, the same contamination confirmation test and evaluation during heat curing as in Example 1 were performed. The results are shown in Table 1.

[Example 4]

An adhesive composition was prepared by the same method as in Example 3 except that 0.20 parts of (D2) a compound having the following formula (63) (numerical average molecular weight: 1,024, Si-H group amount: 0.098 mol/100 g) was further added to 100 parts of (A1) the polymer having the formula (58) in Example 3. With respect to this adhesive composition, the same contamination confirmation test and evaluation during heat curing as in Example 1 were performed. The results are shown in Table 1. In the formulas, Me represents a methyl group.

[Chem. 46]

(D2)

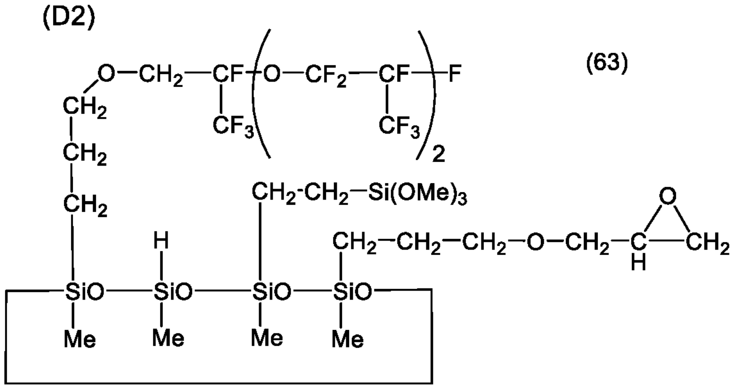

(63)

[Example 5]

To 100 parts of (A2) a polymer having the following formula (64) (numerical average molecular weight: 6,450, weight loss ratio: 0.4%, viscosity: 60 mPa·s, vinyl group amount: 0.031 mol/100 g), 0.033 parts of (C1) the ethanol solution (platinum concentration: 3.0 wt%) of a platinum-divinyltetramethyldisiloxane complex, 0.25 parts of the 60 wt% toluene solution of ethynylcyclohexanol, 19.4 parts of (B1) the compound having the formula (59), 1.79 parts of (B2) the compound having the formula (60), 2.0 parts of (D1) the compound having the formula (61), and 0.2 parts of (E1) the compound having the formula (62) were added and mixed to prepare an adhesive composition. With respect to this adhesive composition, the same contamination confirmation test and evaluation during heat curing as in Example 1 were performed. The results are shown in Table 1.
[Chem. 47]

$$(A2)\ CH_2{=}CH\text{-}CH_2\text{-}O\text{-}CH_2\text{-}CF_2\text{-}(OC_2F_4)_n\text{-}(OCF_2)_m\text{-}O\text{-}CF_2\text{-}CH_2\text{-}O\text{-}CH_2\text{-}CH{=}CH_2 \qquad (64)$$

wherein m and n are integers of 1 or more, and the average value of m + n is 34.

[Example 6]

An adhesive composition was prepared in the same manner as in Example 3 except that 100 parts of (A3) a polymer having the following formula (65) (numerical average molecular weight: 15,630, weight loss ratio: 0.4%, viscosity: 11,000 mPa·s, vinyl group amount: 0.012 mol/100 g) was used instead of (A1) the polymer having the formula (58) in Example 3. With respect to this adhesive composition, the same contamination confirmation test and evaluation during heat curing as in Example 1 were performed. The results are shown in Table 1. In the formulas, Me represents a methyl group.

[Chem. 48]

(A3)

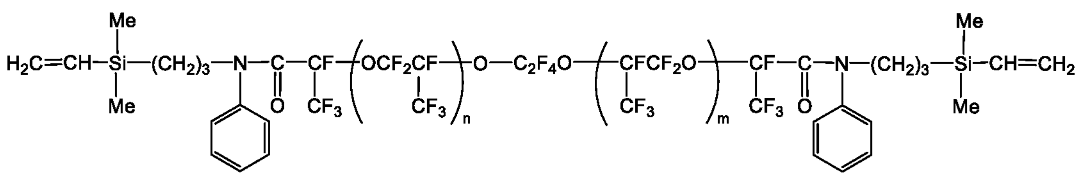

(65)

wherein m and n are integers of 1 or more, and the average value of m + n is 90.

[Comparative Example 1]

An adhesive composition was prepared in the same manner as in Example 1 except for using 1.83 parts of

(B') a compound having the following formula (66) (numerical average molecular weight: 762, weight loss ratio: 100%, Si-H group amount: 0.394 mol/100 g) in place of (B1) the compound having the formula (59) and changing (B2) the compound having the formula (60) to 1.18 parts in Example 1. With respect to this adhesive composition, the same contamination confirmation test and evaluation during heat curing as in Example 1 were performed. The results are shown in Table 1. In the formulas, Me represents a methyl group.

[Chem. 49]

(B')

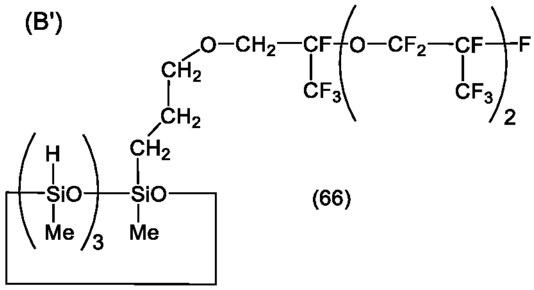

(66)

[Comparative Example 2]

An adhesive composition was prepared in the same manner as in Example 1 except that 100 parts of (A4) a polymer having the following formula (67) (numerical average molecular weight: 1,810, weight loss ratio: 28%, viscosity: 28 mPa·s, vinyl group amount: 0.10 mol/100 g) was used instead of 100 parts of (A1) the polymer having the formula (58) in Example 1. With respect to this adhesive composition, the same contamination confirmation test and evaluation during heat curing as in Example 1 were performed.
[Chem. 50]

(A4) $CH_2=CH-CH_2-O-CH_2-CF_2-(OC_2F_4)_n-(OCF_2)_m-O-CF_2-CH_2-O-CH_2-CH=CH_2$ (67)

wherein m and n are integers of 1 or more, and the average value of m + n is 9.

[Table 1]

| Adhesive composition | Occurrence of contamination |
|---|---|
| Example 1 | No |
| Example 2 | No |
| Example 3 | No |
| Example 4 | No |
| Example 5 | No |
| Example 6 | No |
| Comparative Example 1 | Yes |
| Comparative Example 2 | Yes |

FIG. 1 shows appearance photographs of the sensor chip before and after the contamination confirmation test during heat curing in Example 1. A circular pattern in the middle of the photograph in FIG. 1 is the gold pad of the sensor chip. In Example 1, as compared with the sensor chip (FIG. 1(a)) in the state before the test (blank), no appearance defect including discoloration was observed in the sensor chip after the test (FIG. 1(b)). Also in Examples 2 to 6, similarly to Example 1, gold pad contamination on the sensor chip (adhesion of liquid or oily impurities to the gold pad and discoloration) was not confirmed. On the other hand, FIG. 2 shows appearance photographs of the sensor chip before and after the contamination confirmation test during heat curing in Comparative Example 1. In Comparative Example 1, as compared with the sensor chip (FIG. 2(a)) in the state before the test (blank), it was confirmed that liquid or oily impurities adhered to the sensor chip after the test (FIG. 2(b)) and discolored. Also in Comparative Example 2, similarly to Comparative Example 1, gold pad contamination of the sensor chip was confirmed.

(Adhesion test)

Two test panels of 100 mm × 25 mm of various adherends (aluminum (Al), stainless steel (SUS), polybutylene terephthalate (PBT), polyphenylene sulfide (PPS)) described in Table 2 were superposed with layers of the respective compositions obtained in Examples 1 to 6 and Comparative Examples 1 and 2 having a thickness of 1 mm sandwiched therebetween such that the respective end portions overlapped each other by 10 mm, and the layers were heated at 150°C for 1 hour to cure the compositions, thereby preparing adhesion test pieces. Subsequently, the test pieces were subjected to a tensile shear adhesion test (tension rate: 50 mm/min) to evaluate adhesion strength (shear bond strength) and cohesive failure rate. These results are shown in Table 2. In the table, the numerical values in the upper row are shear bond strengths, and the numerical values in parentheses in the lower row are cohesive failure rates (%).

[Table 2]

| Shear bond strength (MPa) | | Example 1 | Example 2 | Example 3 | Example 4 | Example 5 | Example 6 | Comp. Ex. 1 | Comp. Ex. 2 |
|---|---|---|---|---|---|---|---|---|---|
| Adherend | A1 | 0.4 (90) | 0.4 (100) | 1.4 (100) | 1.4 (100) | 0.5 (100) | 1.5 (100) | 0.4 (90) | 0.1 (0) |
| | SUS | 0.6 (100) | 0.6 (100) | 2.0 (100) | 1.9 (100) | 0.6 (100) | 1.7 (100) | 0.6 (100) | 0.1 (0) |
| | PBT | 0.5 (90) | 0.5 (100) | 1.8 (100) | 1.8 (100) | 0.4 (80) | 1.6 (100) | 0.2 (50) | 0.1 (0) |
| | PPS | 0.4 (80) | 0.5 (100) | 1.5 (100) | 1.4 (100) | 0.4 (90) | 1.5 (100) | 0.1 (5) | 0.1 (0) |

**Claims**

1. An adhesive composition comprising:

(A) 100 parts by weight of a linear perfluoropolyether compound having at least two alkenyl groups in one molecule, and having a numerical average molecular weight of 2,000 or more and a weight loss ratio of 1% or less upon heating component (A) alone at 150°C for 1 hour,
(B) a fluorine-containing organohydrogenpolysiloxane compound having two or more hydrogen atoms bonded to silicon atoms in one molecule and one or more fluorine-containing organic groups, being free of an epoxy group and a trialkoxysilyl group, and having a numerical average molecular weight of 1,000 or more and 4,000 or less and a weight loss ratio of 20% or less upon heating component (B) alone at 150°C for 1 hour, component (B) being present in an amount to give 0.1 to 2.5 mol of hydrogen atoms bonded to silicon atoms in the component (B) per mol of alkenyl groups in the component (A),
(C) 0.1 to 1,000 ppm in terms of platinum group metal atom with respect to the mass of the component (A) of a platinum group metal compound, and
(D) an organohydrogenpolysiloxane compound having one or more hydrogen atoms bonded to silicon atoms and one or more epoxy groups and/or trialkoxysilyl groups bonded to silicon atoms via a carbon atom or a carbon atom and an oxygen atom in one molecule, and having a numerical average molecular weight of 700 or more, component (D) being present in an amount to give 0.005 to 1.5 mol of hydrogen atoms bonded to silicon atoms in the component (D) per mol of alkenyl groups in the component (A).

2. The adhesive composition according to claim 1, wherein the component (A) is a linear perfluoropolyether compound having the following general formula (1):

[Chem. 1]

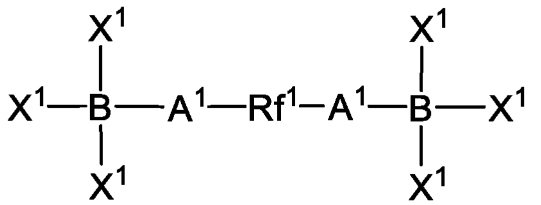

(1)

wherein each $A^1$s is independently any one group selected from a divalent organic group having 1 to 4 carbon atoms which may contain an ether bond or an amide bond, a group having the following general formula (2), and a group having the general formula (3),

[Chem. 2]

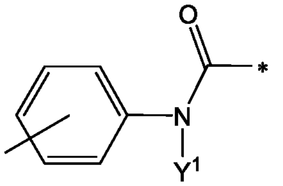

(2)

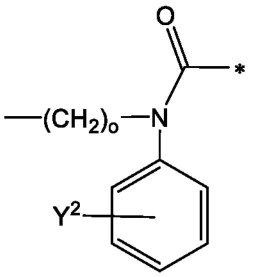

(3)

wherein $Y^1$ is a hydrogen atom, a methyl group, an ethyl group, or a phenyl group, $Y^2$ is a hydrogen atom, a methyl group, an ethyl group, or a trifluoromethyl group, o is an integer of 1 to 6, and a bond with * represents bonding to $Rf^1$,

B is a carbon atom or silicon atom, each $X^1$s is independent, at least two $X^1$s are alkenyl groups, the other $X^1$s are hydrogen atoms (only when B is a carbon atom) or methyl groups, and $Rf^1$ is a divalent perfluoropolyether group.

3. The adhesive composition according to claim 1 or 2, wherein the component (A) has a weight loss ratio of 0.5% or less upon heating the component (A) alone at 150°C for 1 hour.

4. The adhesive composition according to any one of claims 1 to 3, wherein the alkenyl group content of the component (A) is 0.002 to 0.3 mol/100 g.

5. The adhesive composition according to any one of claims 1 to 4, wherein the component (B) is a fluorine-containing organohydrogenpolysiloxane compound having the following general formula (4):

[Chem. 3]

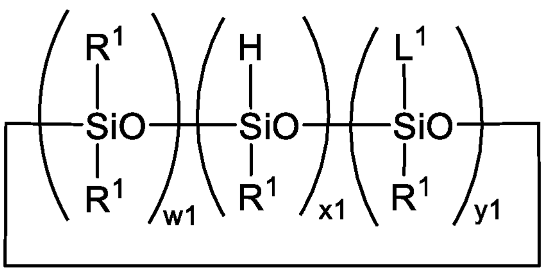

(4)

wherein $R^1$s are unsubstituted or halogen-substituted monovalent hydrocarbon groups, $L^1$ is a monovalent fluorine-containing organic group containing a monovalent perfluoropolyether group having the following general formula (5) which may be bonded to a silicon atom via a divalent linking group, w1 is an integer of 0 to 50, x1 is an integer of 2 to 50, y1 is an integer of 1 to 50, w1 + x1 + y1 is an integer satisfying a numerical average molecular weight of 1,000 to 4,000, and the repeating units in parentheses may be randomly arranged,

$$E\text{-}(C_4F_8O)_c\text{-}(C_3F_6O)_d\text{-}(C_2F_4O)_e\text{-}(CF_2O)_f\text{-}C_gF_{2g}\text{-} \quad (5)$$

wherein E is a fluorine atom or a perfluorooxyalkyl group having 1 to 6 carbon atoms, c, d, e, and f are each independently an integer of 0 to 20, $2 \leq c + d + e + f \leq 20$, g is an integer of 1 to 3, and the repeating units in parentheses may be randomly arranged.

**6.** The adhesive composition according to any one of claims 1 to 5, wherein the component (D) has one or more monovalent perfluoroalkyl groups or monovalent perfluorooxyalkyl groups bonded to a silicon atom via a divalent linking group containing at least one selected from a nitrogen atom, a carbon atom, and an oxygen atom in one molecule.

**7.** The adhesive composition according to any one of claims 1 to 6, further comprising 0.010 to 10 parts by weight of a carboxylic anhydride (E) per 100 parts by weight of the component (A).

**8.** A die attach material comprising the adhesive composition according to any one of claims 1 to 7.

**9.** The die attach material according to claim 8, which is used for an in-vehicle sensor.

**10.** A sealing agent or coating agent for protection comprising the adhesive composition according to any one of claims 1 to 7.

**11.** The sealing agent or coating agent for protection according to claim 10, which is used for a printing or copying device or a fuel cell.

**12.** An electrical or electronic part comprising a cured product of the adhesive composition according to any one of claims 1 to 7.

**13.** The electrical or electronic part according to claim 12, which is an in-vehicle sensor article in which a sensor chip is fixed with the cured product of the adhesive composition.

**14.** The electrical or electronic part according to claim 12, which is a part for a printing or copying device or a part for a fuel cell in which the cured product of the adhesive composition is used as a seal or coating layer for protection.

FIG.1A

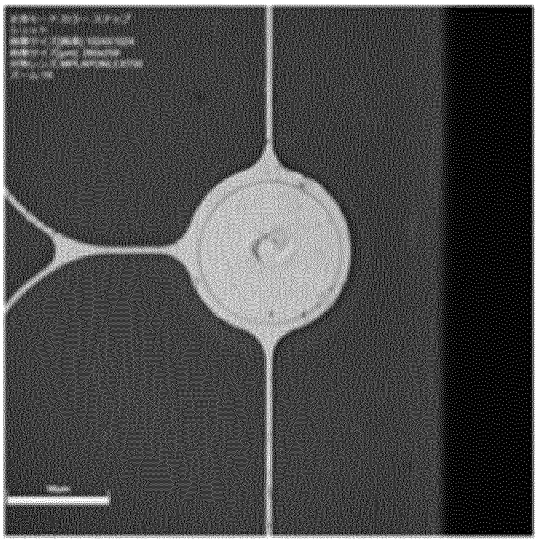

BEFORE TEST

FIG.1B

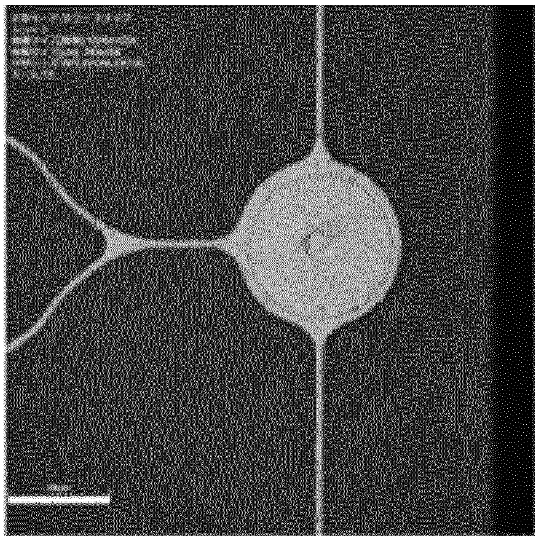

AFTER TEST

FIG.2A

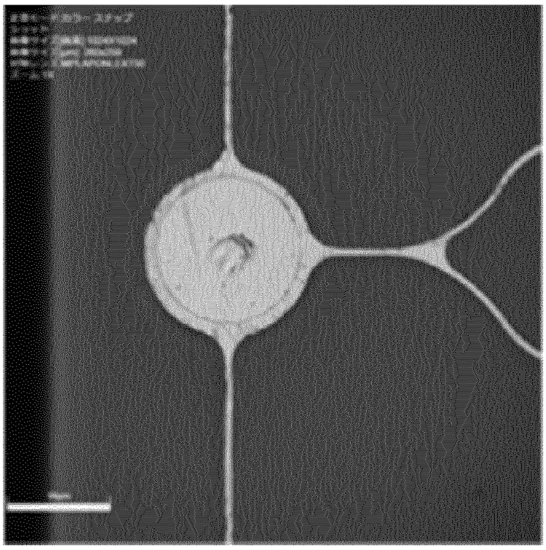

BEFORE TEST

FIG.2B

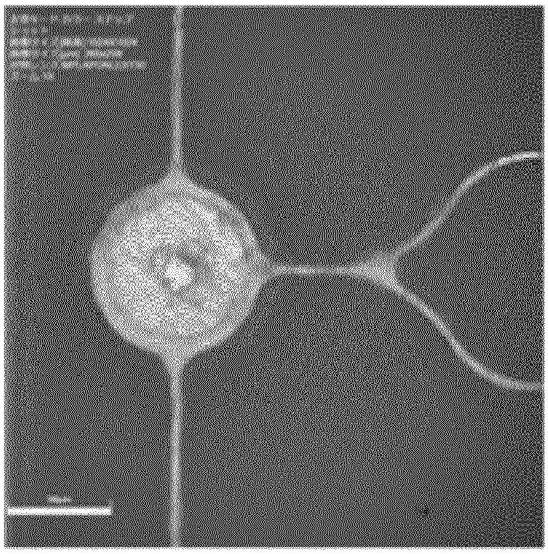

AFTER TEST

## INTERNATIONAL SEARCH REPORT

International application No.
**PCT/JP2021/036571**

**A. CLASSIFICATION OF SUBJECT MATTER**

***C09J 11/06***(2006.01)i; ***H01L 23/29***(2006.01)i; ***H01L 23/31***(2006.01)i; ***C09J 171/02***(2006.01)i; ***C09J 183/05***(2006.01)i; ***C09J 183/06***(2006.01)i; ***C09J 183/07***(2006.01)i; ***H01L 21/52***(2006.01)i
FI: C09J183/05; C09J183/06; C09J171/02; C09J183/07; C09J11/06; H01L21/52 E; H01L23/30 D

According to International Patent Classification (IPC) or to both national classification and IPC

**B. FIELDS SEARCHED**

Minimum documentation searched (classification system followed by classification symbols)

C09J11/06; H01L23/29; H01L23/31; C09J171/02; C09J183/05; C09J183/06; C09J183/07; H01L21/52

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 2005-126618 A (SHIN-ETSU CHEMICAL CO., LTD.) 19 May 2005 (2005-05-19) claims, paragraph [0087] | 1-14 |
| X | JP 2019-006969 A (SHINETSU CHEMICAL CO) 17 January 2019 (2019-01-17) claims, paragraphs [0096], [0101]-[0116] | 1-14 |
| X | JP 2018-123206 A (SHINETSU CHEMICAL CO) 09 August 2018 (2018-08-09) claims, paragraphs [0133], [0141]-[0192] | 1-14 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **30 November 2021** | **14 December 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/036571**

| Patent document cited in search report | Publication date (day/month/year) | Patent family member(s) | Publication date (day/month/year) |
|---|---|---|---|
| JP 2005-126618 A | 19 May 2005 | US 2005/0090602 A1<br>claims, paragraph [0103]<br>EP 1528092 A1 | |
| JP 2019-006969 A | 17 January 2019 | US 2018/0371300 A1<br>claims, paragraphs [0111], [0116]-[0137]<br>CN 109111889 A | |
| JP 2018-123206 A | 09 August 2018 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H0995615 A
- JP 4582287 B
- JP 9095615 A